# EUROPEAN PATENT APPLICATION

(11) **EP 4 753 071 A1**
(43) Date of publication of application: **03.06.2026**
(21) Application number: 24849433.8
(22) Date of filing: 18.07.2024
(51) Int. Cl.: H01Q 1/24, H01Q 1/38, H04M 1/02, H01Q 5/30

(54) **ELECTRONIC DEVICE INCLUDING ANTENNA**

(30) Priority: 31.07.2023 KR 20230100106; 22.09.2023 KR 20230127175
(71) Applicant: Samsung Electronics Co., Ltd., Suwon-si, Gyeonggi-do 16677 (KR)
(72) Inventor: JANG, Kyihyun, Suwon-si Gyeonggi-do 16677 (KR); KIM, Kyunggu, Suwon-si Gyeonggi-do 16677 (KR); KIM, Yoonjung, Suwon-si Gyeonggi-do 16677 (KR); KIM, Jiho, Suwon-si Gyeonggi-do 16677 (KR); SEOL, Kyungmoon, Suwon-si Gyeonggi-do 16677 (KR); AN, Seongyong, Suwon-si Gyeonggi-do 16677 (KR); LEE, Minkyung, Suwon-si Gyeonggi-do 16677 (KR)
(74) Representative: HGF
(86) International application number: PCT/KR2024/010365
(87) International publication number: WO 2025/028864

(57) **Abstract**

The electronic device may include a first housing including a rear cover and a frame including a first portion forming a part of a side surface of the electronic device and a second portion extending from the first portion to correspond to the rear cover, a second housing formed to be inserted into or withdrawn from the first housing, a slit formed in the second portion of the frame, a flexible display including a metal layer; and a wireless communication circuit. At least a portion of the flexible display may overlap the slit in a first state in which the second housing is inserted into the first housing. The wireless communication circuit may be configured to feed power to the first portion of the frame and to transmit and/or receive RF signals of a first frequency band on based on an electrical path formed in the first portion of the frame and a conductive portion in which the slit is formed.

## Description

### [Technical Field]

The disclosure relates to an electronic device including an antenna.

### [Background Art]

An electronic device may include a display having a larger area in order to provide a wide screen. However, since the size of the electronic device also increases as the size of the display increases, there may be a limit to the size of the display. In order to overcome this limitation, a rollable electronic device as a next-generation display device may include a flexible display. The flexible display may be selectively slid into the housing, whereby the flexible display may have a large area for providing a large screen while maintaining the size of the electronic device.

While electronic devices having communication functions are miniaturized and reduced in weight, a plurality of antennas may be included in a single electronic device in order to provide mobile communication services across different frequency bands with a single electronic device. For example, in the IEEE 802.11n, IEEE 802.11ac, and IEEE 802.11ax standards, a multi-input multi-output (MIMO) scheme is defined, and MIMO antennas related to 2G (generation)/3G/4G/5G may be included in an electronic device.

### [Disclosure of Invention]

### [Solution to Problem]

According to one embodiment, an electronic device may include a rear surface cover, a first housing including a rear surface cover, a frame including a first portion forming a portion of a side surface of the electronic device and a second portion extending from the first portion to correspond to a rear surface cover, and a second housing formed to be slid into an interior of the first housing or to be slid out from the interior of the first housing. a slit formed in the second portion of the frame, a flexible display including a metal layer, and a wireless communication circuit. At least a portion of the flexible display may overlap the slit in a first state in which the second housing is slid into the first housing. The wireless communication circuit may be configured to feed power to the first portion of the frame and to transmit and/or receive radio frequency (RF) signals in a first frequency band based on an electrical path formed in the first portion of the frame and in a conductive portion including the slit.

### [Brief Description of Drawings]

FIG. 1 is a view illustrating an electronic device according to an embodiment within a network environment.
FIG. 2 is a front view illustrating an electronic device when the electronic device is in a first state or a second state, according to an embodiment.
FIG. 3 is a rear view illustrating the electronic device when the electronic device is in the first state or the second state, according to an embodiment.
FIG. 4 illustrates front perspective views of a second housing according to states of an electronic device according to an embodiment.
FIG. 5 illustrates rear perspective views of an electronic device according to states of the electronic device according to an embodiment.
FIG. 6 is a view illustrating an internal portion when a roller unit according to an embodiment is viewed in a third direction when an electronic device is in the first state.
FIG. 7 is a view illustrating a structure of a first housing according to an embodiment.
FIG. 8 is a view illustrating positions of a slit and a flexible display when an electronic device according to an embodiment is in the first state.
FIG. 9 is a view illustrating, in comparison, an electrical path in a case where a slit is formed in the second portion according to an embodiment and an electrical path in a case where a slit is not formed in the second portion according to an embodiment.
FIG. 10 is a view illustrating a position at which a slit is formed according to an embodiment.
FIG. 11 is a view illustrating cases in which slots are formed at first to third positions according to an embodiment.
FIG. 12 illustrates radiation efficiency graphs of RF signals corresponding to cases where slots are respectively formed at first to third positions according to an embodiment.
FIG. 13 illustrates radiation efficiency graphs of RF signals radiated by a first portion depending on respective lengths of an electronic device according to an embodiment.
FIG. 14 is a view illustrating a switch circuit connected to a ground according to an embodiment.
FIG. 15 is a view illustrating, in comparison, current distributions in a case where a switch circuit is opened and in a case where the switch circuit is shorted, according to an embodiment.
FIG. 16 is a view illustrating, in comparison, radiation-efficiency graphs in a case where a switch circuit is opened and in a case where the switch circuit is shorted, according to an embodiment.
FIG. 17 illustrates radiation-efficiency graphs of antennas that radiate RF signals in the second frequency band depending on a size of a gap between a slit and a flexible display according to an embodiment.
FIG. 18 is a view illustrating, in comparison, a case where a slit is not formed, a case where a slit and a ground are electrically disconnected, and a case where a slit and a ground are electrically connected, according to an embodiment.
FIG. 19 illustrates various widths of slits formed in the second portion according to an embodiment.
FIG. 20 illustrates radiation-efficiency graphs of antennas in cases where slits having various widths are formed according to an embodiment.
FIG. 21 illustrates various positions of slits formed in the second portion according to an embodiment.
FIG. 22 illustrates radiation-efficiency graphs of antennas in cases where slits having various widths are formed according to an embodiment.
FIG. 23 illustrates various heights of slits formed in the second portion according to an embodiment.
FIG. 24 illustrates radiation-efficiency graphs of antennas in cases where slits having various heights are formed according to an embodiment.
FIG. 25 illustrates various heights of slits formed in the second portion according to an embodiment.
FIG. 26 illustrates radiation-efficiency graphs of antennas in cases where slits having various heights are formed according to an embodiment.
FIG. 27 illustrates various positions of slits formed in the second portion according to an embodiment.
FIG. 28 illustrates radiation-efficiency graphs of antennas in cases where slits having various positions are formed according to an embodiment.

In connection with the description of the drawings, the same or similar components may be denoted by the same or similar reference numerals.

### [Mode for the Invention]

Hereinafter, various embodiments of the disclosure will be described with reference to the accompanying drawings. However, this is not intended to limit the disclosure to specific embodiments, and it is to be understood that various modifications, equivalents, and/or alternatives of the embodiments of the disclosure are included within the scope of the disclosure.

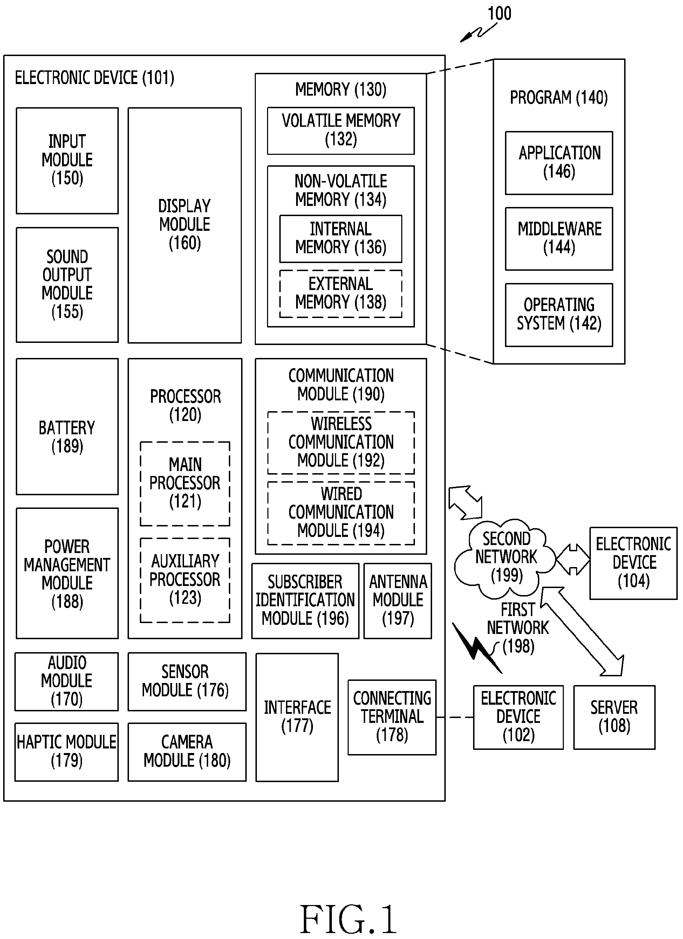

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197. According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

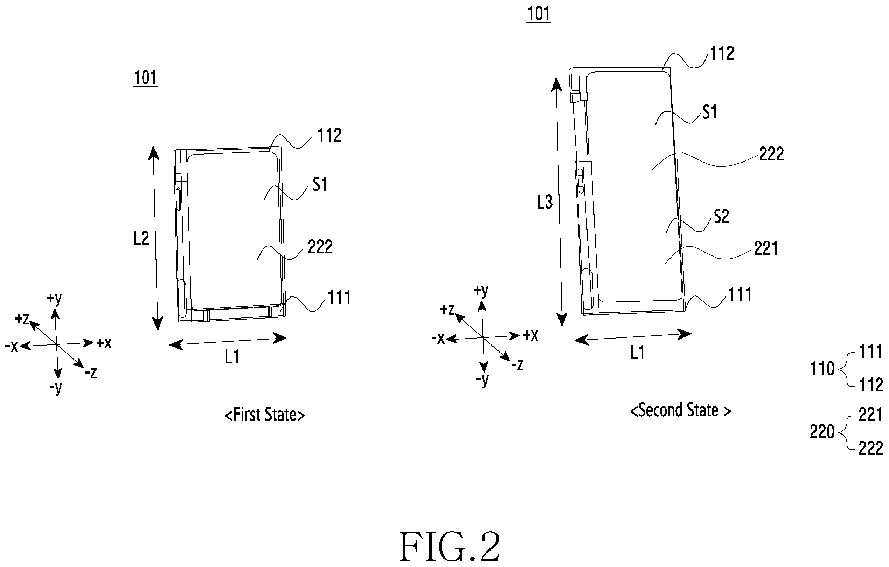

FIG. 2 is a front view illustrating an electronic device when the electronic device is in a first state or a second state, according to an embodiment.

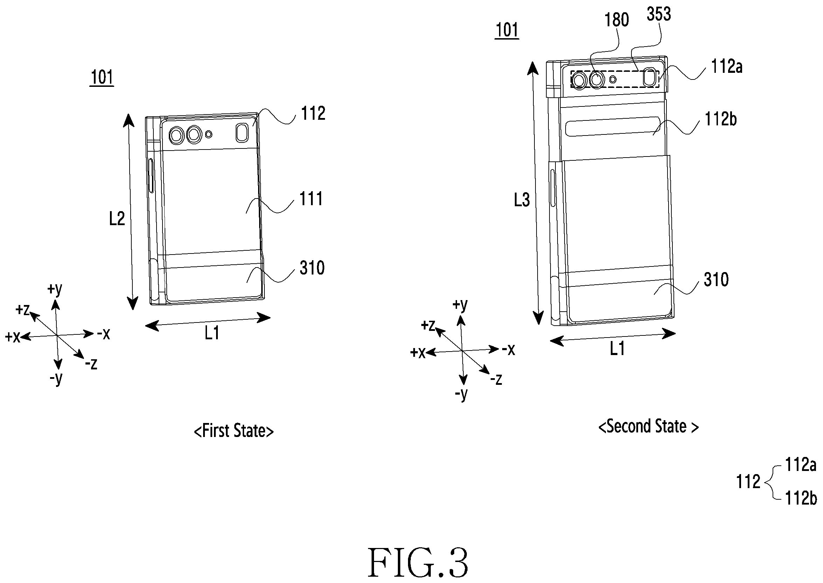

FIG. 3 is a rear view illustrating the electronic device when the electronic device is in the first state or the second state, according to an embodiment.

Referring to FIGS. 2 and 3, an electronic device 101 according to an embodiment may include a housing 110 forming an exterior appearance.

According to an embodiment, the housing 110 may form a partial area of the front surface, a partial area of the rear surface, and/or a side surface of the electronic device 101. As another example, the housing 110 may form a portion of a side surface region and/or a rear surface of the electronic device 101. For example, the housing 110 may include a conductive material (e.g., a metal) and/or a non-conductive material (e.g., glass, an injection-molded member).

According to an embodiment, the housing 110 may include a first housing 111 and a second housing 112 that is connected to the first housing 111 so as to be slidable within a predetermined range (e.g., slide-in, slide-out). For example, the first housing 111 may include a space (or a mounting space) into which the second housing 112 may be slid. The second housing 112 may be configured to be slid in (entered) toward the inside of the first housing 111 or to be slid out (withdrawn) toward the exterior of the first housing 111.

According to an embodiment, the second housing 112 may include an upper portion 112a in which a camera module 180 is disposed, and a lower portion 112b that is slid in toward the inside of the first housing 111. For example, the upper portion 112a may include a cover for the camera module 180 and/or a side surface member forming at least a portion of a side surface of the electronic device 101.

As another example, the upper portion 112a may be exposed to the exterior of the electronic device 101 in both a first state in which the second housing 112 is slid into the first housing 111 and a second state in which the second housing 112 is slid out from the first housing 111. The lower portion 112b may be a portion that is disposed inside the second housing 112 in the first state in which the second housing 112 is slid into the first housing 111. The lower portion 112b may be exposed to the exterior of the electronic device 101 in the second state in which the second housing 112 is slid out to the exterior of the first housing 111.

According to an embodiment, the first housing 111 may include at least one camera hole 353. For example, the at least one camera hole 353 may correspond to a hole through which at least one lens of the camera module 180 is exposed. Through the at least one camera hole 353, light from the exterior of the electronic device 101 may be incident to the camera module 180 that is disposed inside the electronic device 101.

According to an embodiment, the electronic device 101 may have a first state and/or a second state. In another embodiment, the electronic device 101 may have a first state, a second state, and/or an intermediate state between the first state and the second state.

In an embodiment, the first state and the second state of the electronic device 101 may be determined depending on a relative position of the second housing 112 with respect to the first housing 111. For example, the state in which the second housing 112 is slid in a direction approaching the first housing 111 (e.g., the +x direction) and the first housing 111 and the second housing 112 are adjacent to or in contact with each other may be referred to as the first state. As another example, the state in which the second housing 112 is slid in a direction away from the first housing 111 (e.g., the -x direction) may be referred to as the second state.

According to an embodiment, the flexible display 220 may include a first display portion 221 and a second display portion 222. For example, the first display portion 221 may be disposed inside the electronic device 101 in the first state and may be exposed to the exterior of the electronic device 101 in the second state. For example, the second display portion 222 may be exposed to the exterior of the electronic device 101 through a front surface of the electronic device 101 in both the first state and the second state.

According to an embodiment, the first state and the second state of the electronic device 101 may be determined based on the size of the flexible display 220 that is exposed to the exterior. For example, only the second display portion 222 of the flexible display 220 may be exposed to the exterior of the electronic device 101, and a state in which the flexible display 220 exposed to the exterior has a first size S1 may correspond to the first state. In another example, the first display portion 221 and the second display portion 222 of the flexible display 220 may be exposed to the exterior of the electronic device 101, and a state in which the flexible display 220 exposed to the exterior has a size corresponding to the sum of a first size S1 and a second size S2 (e.g., a third size S1+S2) may correspond to the second state. In still another example, a state in which the flexible display 220 exposed to the exterior has a size between the first size S1 and the third size S1+S2 may correspond to an intermediate state.

According to an embodiment, the electronic device 101 may have a first length L1 in a lateral direction (e.g., the x-axis direction), and the electronic device 101 may have different lengths in a vertical direction (e.g., the y-axis direction) in the first state and the second state, respectively. For example, the electronic device 101 may have a second length L2 in the vertical direction (e.g., the y-axis direction) in the first state. In another example, the electronic device 101 may have a third length L3 in the vertical direction (e.g., the y-axis direction) in the second state.

For example, the electronic device 101 may have a width corresponding to the first length L1, may have a height corresponding to the second length L2 in the first state, and may have a height corresponding to the third length L3 in the second state.

According to an embodiment, the electronic device 101 may be transitioned between the first state and the second state by a user operation or a mechanical operation. According to another embodiment, the housing 110 may include a button in a portion, and the electronic device 101 may be switched between the first state and the second state through the user's manipulation (e.g., an input of pushing or touching the button).

According to an embodiment, the flexible display 220 may occupy most of the front surface of the electronic device 101. For example, the front surface of the electronic device 101 may include a flexible display 220 and a bezel region partially surrounding the periphery of the flexible display 220. According to an embodiment, the flexible display 220 may be disposed to include at least a portion of a flat shape or at least a portion of a curved shape.

According to an embodiment, the flexible display 220 may include a first display portion 221 and a second display portion 222 that extends from the first display portion 221. In an embodiment, the second display portion 222 of the flexible display 220 may be slid into the interior of the housing 110 or slid out to the exterior of the housing 110 depending on the state of the electronic device 101. For example, when the electronic device 101 is in the first state, the second display portion 222 of the flexible display 220 may be slid into and disposed inside the housing 110, and may not be viewed from the exterior. In another example, when the electronic device 101 is in the second state, the second display portion 222 of the flexible display 220 may be slid out from the exterior of the housing 110 and disposed outside the housing 110, and may be viewed from the exterior.

The configurations of the electronic device 101 illustrated in FIGS. 2 and 3 are provided merely to describe an example of an electronic device 101 in which the display area may be expanded, and the configurations of the electronic device 101 are not limited to those illustrated in FIGS. 1 and 2.

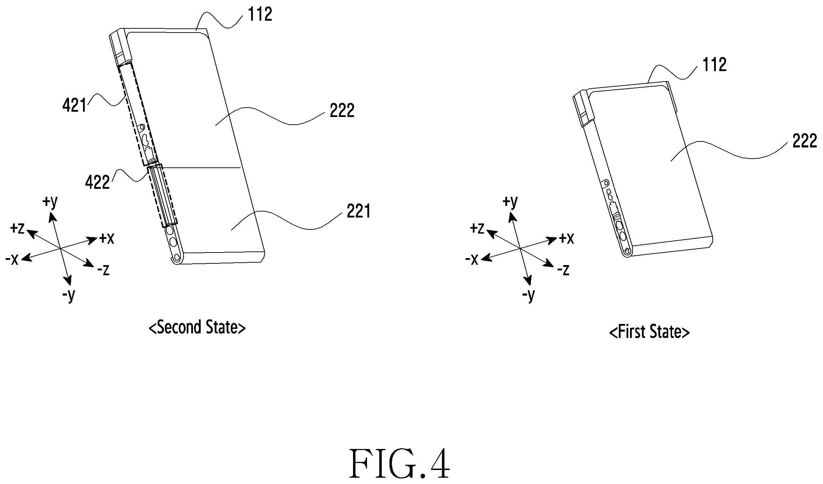

FIG. 4 illustrates front perspectives view of a second housing according to states of an electronic device according to an embodiment.

Referring to FIG. 4, the electronic device 101 according to an embodiment may include a first rail 421 and a second rail 422 for sliding of the second housing 112.

According to an embodiment, in a process in which the electronic device 101 is transitioned from the second state to the first state, the second rail 422 may move in a first direction (e.g., the +y direction) along the first rail 421. For example, the first rail 421 may include a groove that is elongated in the first direction (e.g., the +y direction). The second rail 422 may be movable with respect to the groove. The second rail 422 may move in the first direction (e.g., the +y direction) along the groove elongated in the first direction.

According to an embodiment, in a process in which the electronic device 101 is transitioned from the first state to the second state, the second rail 422 may move in a second direction (e.g., the -y direction) along the first rail 421. For example, the first rail 421 may include a groove in which the second rail 422 is movable. The second rail 422 may move in the second direction (e.g., the -y direction) along the groove.

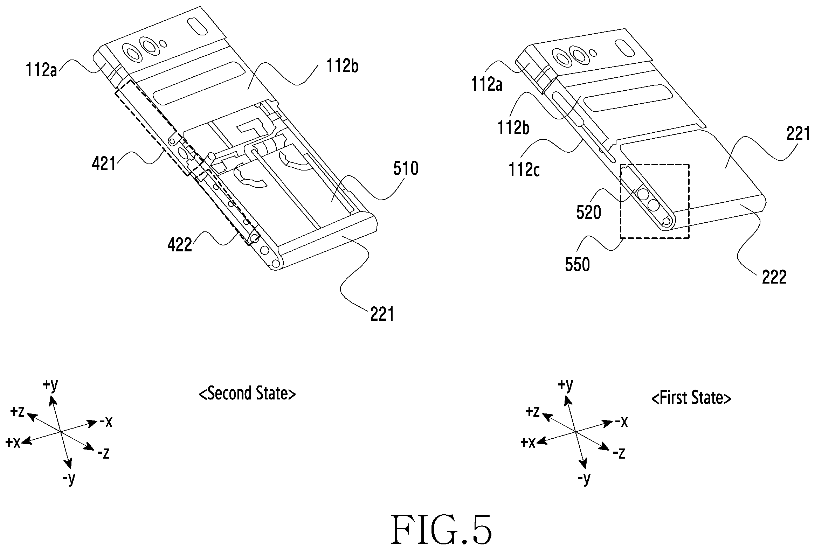

FIG. 5 illustrates rear perspective views of an electronic device according to states of an electronic device according to an embodiment.

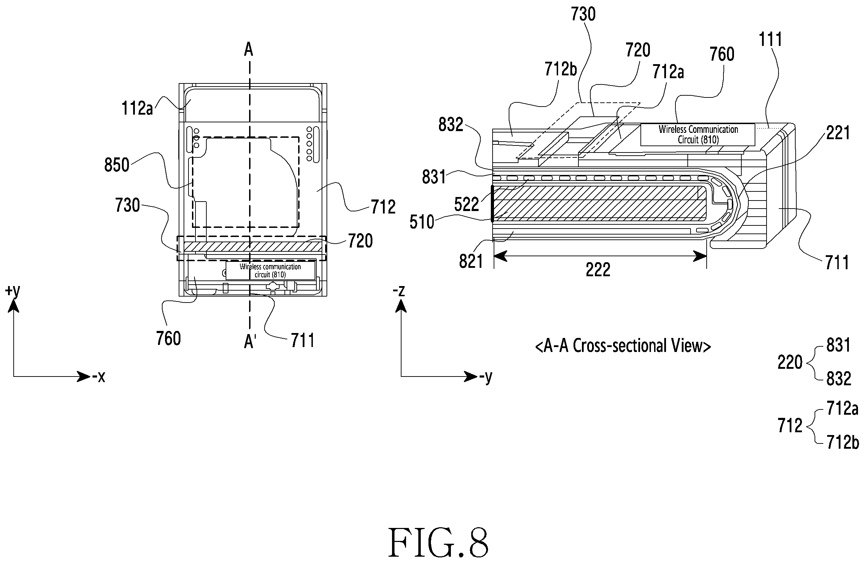

Referring to FIG. 5, the electronic device 101 according to an embodiment may further include a battery 510 for supplying power to electronic components. For example, the battery 510 may be disposed in a space that is provided inside the first housing 111. For example, the battery 510 may supply power to a processor 120 (e.g., a communication processor) and/or a wireless communication circuit (e.g., the wireless communication circuit 810 of FIG. 8).

According to an embodiment, in the second state, the first display portion 221 may be disposed in a front direction of the electronic device 101 (e.g., the +z direction). In the first state, the first display portion 221 may be disposed in a rear direction of the electronic device 101 (e.g., a -z direction), and the second display portion 222 may be disposed in the front direction of the electronic device 101 (e.g., the +z direction).

In the disclosure, it has been described that the electronic device 101 may include the flexible display 220, and that the flexible display 220 may include the first display portion 221 and the second display portion 222, but this is merely an example. For example, the first display portion 221 of the flexible display 220 may be described as being included in the first housing 111, and the second display portion 222 may be described as being included in the second housing 112.

Although not illustrated in FIG. 5 of the disclosure, in the second state, as the first housing 111 is located in the rear direction of the electronic device 101 (e.g., the -z direction) with reference to the battery 510, the battery 510 may not be exposed to the exterior of the electronic device 101.

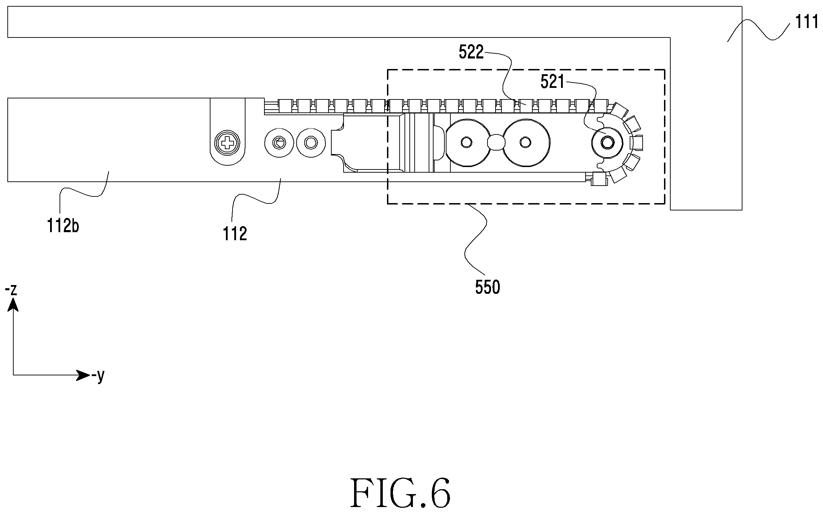

According to an embodiment, the electronic device 101 may include a roller unit 550 for sliding of the second housing 112 with respect to the first housing 111. For example, the roller unit 550 may be disposed inside the housing 110. For example, the roller unit 550 may be coupled to and fixed to the first housing 111. Hereinafter, FIG. 6 illustrates a case in which the roller unit 550 is viewed in a third direction (e.g., the -x direction).

FIG. 6 is a view illustrating an internal portion when a roller unit is viewed in a third direction when an electronic device is in the first state, according to an embodiment.

Referring to FIG. 6, the roller unit 550 according to an embodiment may include a roller 521 for movement of the flexible display 220 and a plurality of bars 522. In the disclosure, the roller unit 550 has been described as a component for movement of the flexible display 220, but this is merely an example. For example, as the roller unit 550 rotates, the flexible display 220 and the second housing 112 may move together. Accordingly, the roller unit 550 may also be a component for movement of the second housing 112.

According to an embodiment, as the roller 521 rotates, the plurality of bars 522 may move, and as the plurality of bars 522 move, the flexible display 220 disposed on the plurality of bars 522 may move.

For example, when a state of the electronic device 101 is transitioned from the first state to the second state, the roller 521 may rotate in a clockwise direction. The plurality of bars 522 may move in the clockwise direction as the roller 521 rotates in the clockwise direction. For example, as the roller 521 rotates in the clockwise direction, the plurality of bars 522 may move in the clockwise direction along the second housing 112. In this case, a lower portion 112b of the second housing 112 may be slid out from the interior of the first housing 111, and the first display portion 221 may be exposed to the exterior of the electronic device 101.

In another example, when the state of the electronic device 101 is transitioned from the second state to the first state, the roller 521 may rotate in a counterclockwise direction. The plurality of bars 522 may move in the counterclockwise direction as the roller 521 rotates in the counterclockwise direction. For example, as the roller 521 rotates in the counterclockwise direction, the plurality of bars 522 may move in the counterclockwise direction along the second housing 112. In this case, the lower portion 112b of the second housing 112 may be slid into the interior of the first housing 111, and the first display portion 221 may be slid into the interior of the electronic device 101.

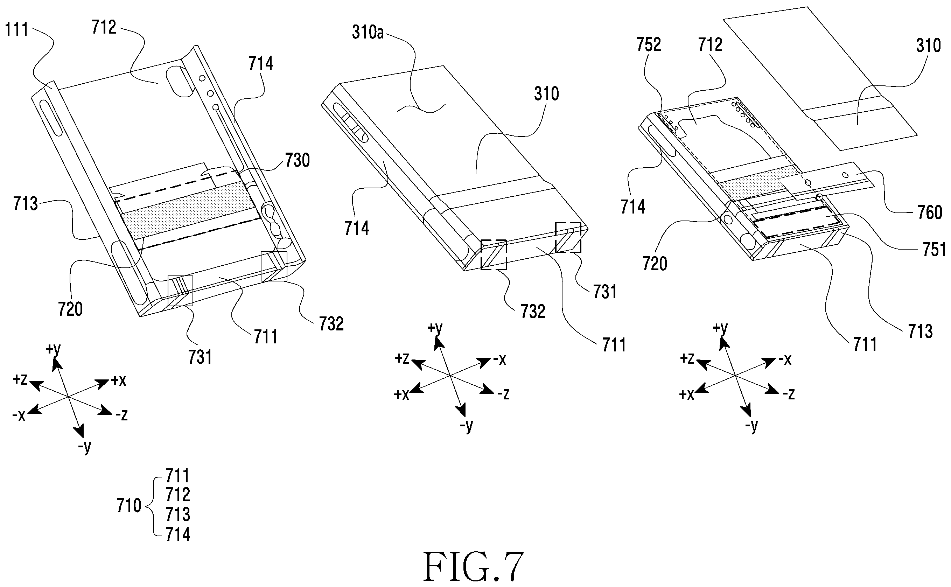

FIG. 7 is a view illustrating a structure of a first housing according to an embodiment.

Referring to FIG. 7, the first housing 111 according to an embodiment may include a frame 710 (or a side surface member). For example, the frame 710 may include a first portion 711 that forms at least a portion of a side surface of the electronic device 101, and/or a second portion 712 that extends from the first portion 711. In an example, the second portion 712 may extend from the first portion 711 in a direction perpendicular to the first portion 711 (e.g., the +y direction).

For example, the frame 710 may include the first portion 711, the second portion 712, and a third portion 713 and/or a fourth portion 714 that forms at least a portion of the side surface.

According to an embodiment, the third portion 713 may be elongated in the first direction (e.g., the +y direction), and the fourth portion 714 may be elongated in the first direction (e.g., the +y direction). For example, the first direction (e.g., the +y direction) may be a direction toward the second portion 712 from the first portion 711. For example, the first direction (e.g., the +y direction) may be a direction in which the second portion 712 is located with reference to the first portion 711.

According to an embodiment, one or more of the first portion 711, the second portion 712, the third portion 713, and/or the fourth portion 714 may include, at least in part, a conductive material and may operate as an antenna radiator. For example, a wireless communication circuit (e.g., the wireless communication circuit 810) to be described below may feed power to the first portion 711, the second portion 712, the third portion 713, and/or the fourth portion 714, and may transmit and/or receive radio frequency (RF) signals of a predetermined frequency band (e.g., a first frequency band).

According to an embodiment, a first segmentation portion 731 and/or a second segmentation portion 732 may be formed in the first portion 711. For example, the first portion 711 and the third portion 713 may be segmented by the first segmentation portion 731. The first portion 711 and the fourth portion 714 may be segmented by the second segmentation portion 732.

In the disclosure, it has been described, as merely an example, that the first segmentation portion 731 and the second segmentation portion 732 are formed in or included in the first portion 711. For example, the frame 710 may also be described as including the first segmentation portion 731 and the second segmentation portion 732. For example, the frame 710 may include segmentation portions disposed between the portions thereof. For example, the frame 710 may include the first segmentation portion 731 disposed between the first portion 711 and the third portion 713 and/or the second segmentation portion 732 disposed between the first portion 711 and the fourth portion 714.

In the disclosure, the term "portion" included in the frame 710 may be replaced with terms such as a conductive portion, a side surface member, a conductive side surface member, or a frame. For example, the first portion 711 may be replaced with a term such as a first conductive portion, a first side surface member, a first conductive side surface member, or a first frame.

In the disclosure, the term "segmentation portion" may be replaced with terms such as a non-conductive portion, a non-conductive slit, a slit, a dielectric, a dielectric material, an insulating portion, or a non-conductive material. For example, the first segmentation portion 731 may be replaced with a term such as a first non-conductive material.

In the disclosure, the term "slit" may be replaced with terms such as a slot, a hole, an opening, or an opening portion.

According to an embodiment, a slit 720 may be formed in the second portion 712 of the frame 710. For example, the slit 720 may be formed in a region of the second portion 712 that is adjacent to the first portion 711.

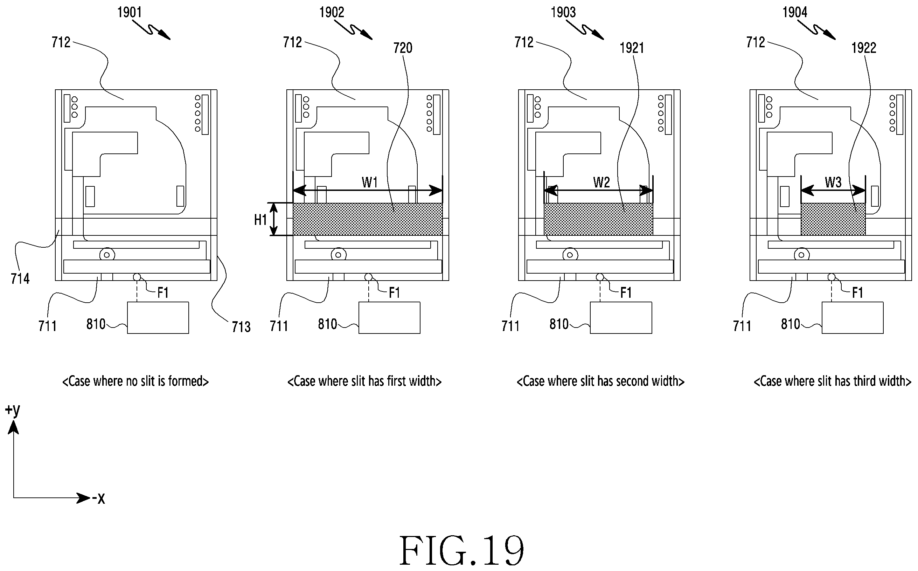

According to an embodiment, the slit 720 may have various shapes. For example, the slit 720 may have a rectangular shape, a circular shape, a triangular shape, or a square shape. In addition, the slit 720 may have various widths and various heights, and this will be described in FIGS. 19 to 28.

According to an embodiment, the first housing 111 may include a rear surface cover 310 that forms a rear surface of the electronic device 101 or is disposed on a rear surface of the electronic device 101. For example, the rear surface cover 310 may be located in a rear direction (e.g., the -z direction) with reference to the second portion 712 of the frame 710. As another example, the rear surface cover 310 may be located below the second portion 712 (e.g., in the -z direction).

According to an embodiment, the rear surface cover 310 may include a non-conductive material. For example, the rear surface cover 310 may include an injection-molded member, glass, resin, and/or plastic.

According to an embodiment, the slit 720 formed in the second portion 712 may overlap with the rear surface cover 310. For example, when viewed in the rear direction (e.g., the -z direction) together with the rear surface cover 310, the slit 720 may overlap with the rear surface cover 310. As a result, the rear surface cover 310 may cover the slit 720 so that the slit 720 formed in the second portion 712 is not exposed to the exterior of the electronic device 101.

According to an embodiment, the second portion 712 may extend from the first portion 711 and may form one surface of the frame 710. For example, the second portion 712 may form a rear surface 310a of the frame 710.

According to an embodiment, the second portion 712 may be a portion that extends from the first portion 711 and is formed to correspond to the rear surface cover 310. For example, the second portion 712 may be a portion that extends from the first portion 711 in the first direction (e.g., the +y direction) and is formed to correspond to the rear surface cover 310. In another example, the second portion 712 may be a portion that extends from the first portion 711 so as to be located above the rear surface cover 310 (e.g., in the +z direction).

According to an embodiment, the electronic device 101 may include a first printed circuit board 760. The first printed circuit board 760 may be disposed between the second portion 712 and the rear surface cover 310. For example, the first printed circuit board 760 may be disposed on the second portion 712 so as to be disposed between the slit 720 and the first portion 711.

According to an embodiment, the second portion 712 of the frame 710 may include a non-conductive region 751 including a non-conductive material and a conductive region 752 including a conductive material and having the slit 720 formed therein. The first printed circuit board 760 may be disposed in the non-conductive region 751 of the second portion 712. For example, the non-conductive region 751 may include a non-conductive material and/or a dielectric. For example, the first printed circuit board 760 may be disposed on the non-conductive region 751.

Sizes, shapes, and boundaries of the non-conductive region 751 and the conductive region 752 of the disclosure illustrated in FIG. 7 are illustrated for convenience of description, and the sizes, shapes, and boundaries of the non-conductive region 751 and the conductive region 752 may be variously modified.

According to an embodiment, the first printed circuit board 760 may provide connection paths for various electronic components (e.g., the processor 120 or a wireless communication circuit). For example, the first printed circuit board 760 may provide connection paths (e.g., conductive vias or conductive lines formed on a layer) used when a wireless communication circuit, which will be described below, feeds power to the first portion 711. In another example, the first printed circuit board 760 may provide connection paths between the processor 120 and the wireless communication circuit or other components (e.g., the battery 510).

In the disclosure, the term "rear surface cover" may be replaced with terms such as a rear surface plate, a cover, or a third housing.

In the disclosure, the term "first printed circuit board" may be replaced with terms such as a sub-printed circuit board, a substrate, a printed circuit board assembly (PBA), or a base. In addition, although not illustrated in FIG. 7, the electronic device 101 may further include a second printed circuit board (or a main printed circuit board).

FIG. 8 is a view illustrating positions of a slit and a flexible display when an electronic device according to an embodiment is in the first state.

Referring to FIG. 8, a wireless communication circuit 810 according to an embodiment may be disposed on the first printed circuit board 760. For example, the wireless communication circuit 810 may feed power to the first portion 711 of the frame 710 and may transmit and/or receive RF signals of a first frequency band based on an electrical path. For example, the wireless communication circuit 810 may feed power to the first portion 711 and may transmit and/or receive RF signals of the first frequency band based on an electrical path formed in the first portion 711 and the second portion 712 including the slit 720.

According to an embodiment, when the wireless communication circuit 810 feeds power to the first portion 711, an electrical path due to the power-feeding may be formed in the first portion 711 and the second portion 712 connected to the first portion 711. For example, an electrical path formed as the wireless communication circuit 810 feeds power to the first portion 711 may be formed along the first portion 711, the second portion 712, and edges of the slit 720. For example, the electrical path may be formed in the first portion 711 and/or in a portion of the second portion 712 in which the slit 720 is formed.

In the disclosure, the description that an electrical path is formed along edges of the slit 720 may mean that the electrical path is substantially formed in the second portion 712 including the slit 720 along the edges of the slit 720.

Referring to the cross-sectional view of the electronic device 101 taken along line A-A', the flexible display 220 may include a metal layer 831 and/or a non-metal layer 832. For example, the metal layer 831 may include copper (Cu). For example, the metal layer 831 may include a metal plate configured to support the flexible display 220.

According to an embodiment, when the electronic device 101 is in the first state, the slit 720 and the metal layer 831 may overlap, at least in part, each other. For example, when the electronic device 101 is in the first state, the slit 720 and the first display portion 221 may overlap, at least in part, each other, and the metal layer 831 may overlap, at least in part, the slit 720. In another example, when the electronic device 101 is in the first state, the slit 720 and the first display portion 221 may overlap, at least in part, each other in a front direction (e.g., a +z direction) of the electronic device 101, and the metal layer 831 may overlap, at least in part, the slit 720 in the front direction. For example, the front direction (e.g., the +z direction) may be a direction in which the second display portion 222 is oriented. For example, the front direction (e.g., the +z direction) may be a direction perpendicular to the second display portion 222.

In another example, when the electronic device 101 is in the first state, the slit 720 and the first display portion 221 may overlap, at least in part, inside the first housing 111 when viewed in the front direction (e.g., the +z direction), and the metal layer 831 may overlap, at least in part, the slit 720 inside the first housing 111 when viewed in the front direction. In another example, when the electronic device 101 is in the first state, when viewed in the front direction (e.g., the +z direction), a portion of the first display portion 221 that is disposed inside the first housing 111 may overlap, at least in part, the slit 720.

According to an embodiment, when the electronic device 101 is in the second state, the slit 720 and the metal layer 831 may not overlap each other inside the first housing 111. For example, when the electronic device 101 is in the second state, the first display portion 221 may be disposed on the front surface of the electronic device 101. In this case, the first display portion 221 may not overlap the slit 720 inside the first housing 111, and the metal layer 831 may not overlap the slit 720 inside the first housing 111. In another example, when the electronic device 101 is in the first state, when viewed in the front direction (e.g., the +z direction), a portion of the first display portion 221 that is disposed inside the first housing 111 and the slit 720 may not overlap each other.

According to an embodiment, when the slit 720 is formed in the second portion 712, the electronic device 101 may be improved in performance of an antenna (e.g., the first portion 711) operating in a first frequency band (e.g., about 600 to 900 MHz band) in the first state, as compared to a case in which the slit 720 is not formed.

For example, as described with reference to FIG. 2, in the first state in which the second housing 112 is slid into the first housing 111, the electronic device 101 may have a height of a second length L2. For example, as compared to the second state, the electronic device 101 may have a relatively small height in the first state, and thus, as a size of a ground decreases, a radiation efficiency of the antenna in the first frequency band may be reduced.

For example, when the slit 720 according to an embodiment is formed in the second portion 712, an electrical path formed as the wireless communication circuit 810 feeds power to the first portion 711 may be formed not only in the first portion 711, but also in the conductive portion 730 along edges of the slit 720. As the slit 720 is formed in the conductive portion 730, a radiation efficiency in the first frequency band corresponding to a relatively low-frequency band (e.g., about 600 to about 900 MHz) may be improved. For example, the electrical path formed as the wireless communication circuit 810 feeds power to the first portion 711 may be formed not only in the first portion 711 operating as an antenna radiator, but also in the conductive portion 730 along edges of the slit 720 formed in the second portion 712 operating as a ground of the antenna radiator. That is, as the slit 720 is formed in the second portion 712, the electrical path may become relatively longer, as compared to a case in which the slit 720 is not formed.

According to an embodiment, the electronic device 101 may secure a relatively high radiation efficiency in a first frequency band (e.g., about 600 to about 900 MHz band), as compared to a case in which the slit 720 is not formed, by using (or based on) the slit 720 formed in the second portion 712.

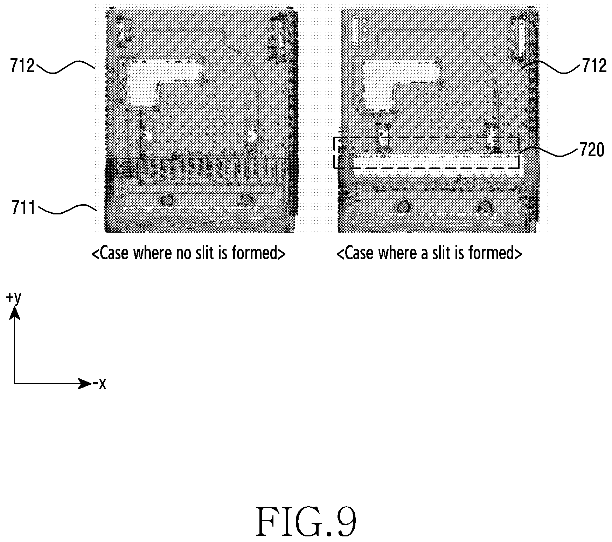

A difference in electrical paths between a case in which the slit 720 is formed in the second portion 712 and a case in which the slit 720 is not formed will be described in more detail with reference to FIG. 9.

According to an embodiment, the slit 720 may be formed across the second portion 712 and, for example, may divide the second portion 712 into a first part 712a and a second part 712b. In an embodiment, the second part 712b may be relatively thicker than the first part 712a, and the first part 712a and the second part 712b may have a step difference. For example, the slit 720 may be formed so as to extend in a third direction (e.g., the -x direction) within the second portion 712.

However, the description regarding positions and thicknesses of the first part 712a and the second part 712b of the second portion 712 is merely illustrative, and the disclosure is not limited thereto.

According to an embodiment, a plurality of bars 522 may be disposed on a rear surface of the first display portion 221 of the flexible display 220, and a plate 821 may be disposed on a rear surface of the second display portion 222. For example, the plate 821 may be a component configured to support the second display portion 222.

According to an embodiment, a groove 850 may be formed in the second portion 712 of the frame 710. For example, the groove 850 of the second portion 712 may be a groove for a near-field communication (NFC) antenna. In another example, the groove 850 of the second portion 712 may be a groove for a magnetic secure transmission (MST) antenna. In another example, the groove 850 of the second portion 712 may be a groove for at least one antenna for wireless charging, NFC, and/or MST.

According to an embodiment, the wireless communication circuit 810 may feed power to at least one antenna (e.g., a coil antenna) for wireless charging, NFC, and/or MST disposed in the groove 850, and may transmit and/or receive RF signals in a predetermined frequency band (e.g., about 13.56 MHz).

In the disclosure, the term "plate" may be replaced with terms such as a support member, a substrate, or a support plate.

FIG. 9 is a view illustrating, in comparison, an electrical path in a case where a slit is formed in the second portion according to an embodiment and an electrical path in a case where a slit is not formed in the second portion according to an embodiment.

Referring to FIG. 9, in a case where the slit 720 according to an embodiment is formed in the second portion 712, it is identified that an electrical path is formed along edges of the slit 720.

In contrast, in a case where the slit 720 is not formed in the second portion 712, it is identified that an electrical path is formed around the first portion 711.

Accordingly, an electrical path in the case where the slit 720 is formed in the second portion 712 may have a relatively long electrical length, as compared to an electrical path in the case where the slit 720 is not formed in the second portion 712.

As a result, by using the slit 720, the electronic device 101 may secure a relatively high radiation efficiency in the first frequency band (e.g., about 600 to about 900 MHz), as compared to a case where the slit 720 is not provided.

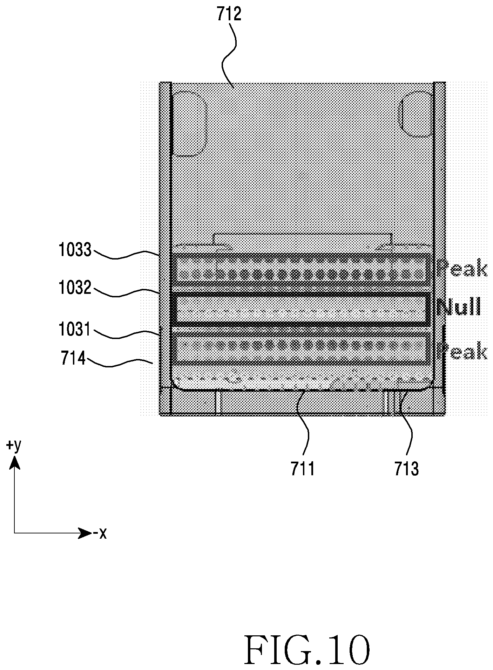

FIG. 10 is a view illustrating a position at which a slit is formed according to an embodiment.

Referring to FIG. 10, when the wireless communication circuit 810 according to an embodiment feeds power to the first portion 711, a current distribution generated by the second portion 712 and a metal layer 831 adjacent to the second portion 712 is illustrated. For example, in the first state, when the wireless communication circuit 810 feeds power to the first portion 711, the second portion 712 and the metal layer 831 may be adjacent to each other. In this case, a capacitance component may be formed or induced between the second portion 712 including a conductive material and the metal layer 831, and, as a result, a current of a harmonic component may be distributed in the second portion 712.

According to an embodiment, at a first position 1031 and a third position 1033 of the second portion 712, a current distribution may have peaks, and, at a second position 1032 of the second portion 712, the current distribution may be minimum (or null).

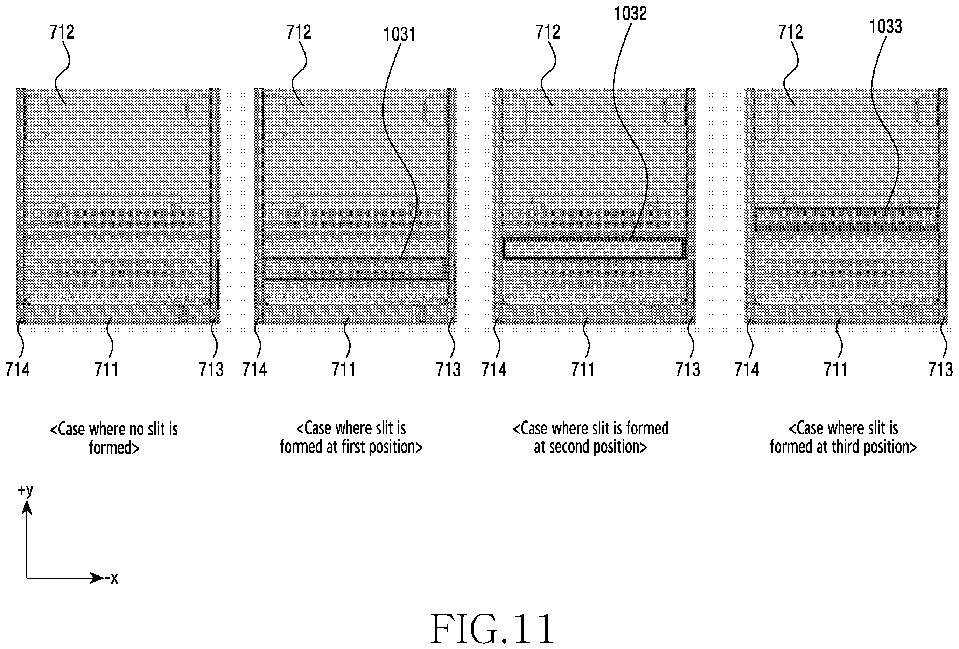

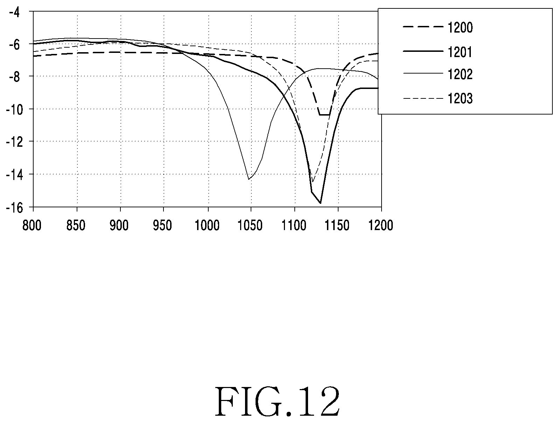

Hereinafter, in FIGS. 11 and 12, a position of a slit 720 determined in consideration of a mounting space in an electronic device 101 and a current distribution caused by a harmonic component will be described.

FIG. 11 is a view illustrating cases in which slots are formed at first to third positions according to an embodiment.

Referring to FIG. 11, the slit 720 according to an embodiment may be formed at a first position 1031 of the second portion 712. The first position 1031 may be a position at which a current distribution formed when the wireless communication circuit 810 feeds power to the first portion 711 in the first state becomes a peak.

According to an embodiment, the slit 720 may be formed at a second position 1032 of the second portion 712. The second position 1032 at which the slit 720 is formed may be a position at which a current distribution formed when the wireless communication circuit 810 feeds power to the first portion 711 in the first state becomes minimum.

According to an embodiment, the slit 720 may be formed at a third position 1033 of the second portion 712. The third position 1033 at which the slit 720 is formed may be a position at which a current distribution formed when the wireless communication circuit 810 feeds power to the first portion 711 in the first state becomes a peak.

According to an embodiment, depending on the position at which the slit 720 is formed in the second portion 712, whether a parasitic resonance generated due to a harmonic component is formed and/or a frequency band in which the parasitic resonance is formed may vary.

According to an embodiment, the slit 720 formed at the first position 1031 in the second portion 712 and the slit 720 formed at the third position 1033 may not affect RF signals in a second frequency band (e.g., about 900 to about 1100 MHz band) radiated by the electronic device 101. For example, when the slit 720 is formed at the point at which a current distribution due to a harmonic component becomes a peak, a frequency band of a parasitic resonance due to the harmonic component may be about 1100 MHz or higher. Accordingly, even when the slit 720 is formed at the first position 1031 of the second portion 712 or when the slit 720 is formed at the third position 1033, a radiation efficiency of an antenna that radiates RF signals in the second frequency band (e.g., about 900 to about 1100 MHz band) may be substantially unaffected.

However, due to a layout structure in the electronic device 101, the first printed circuit board 760 may need to be disposed at the first position 1031. In addition, when the slit 720 is formed at the third position 1033, a distance from a feeding point when the wireless communication circuit 810 feeds power to the first portion 711 may be relatively long, and thus an effect on radiation efficiency may not be significant.

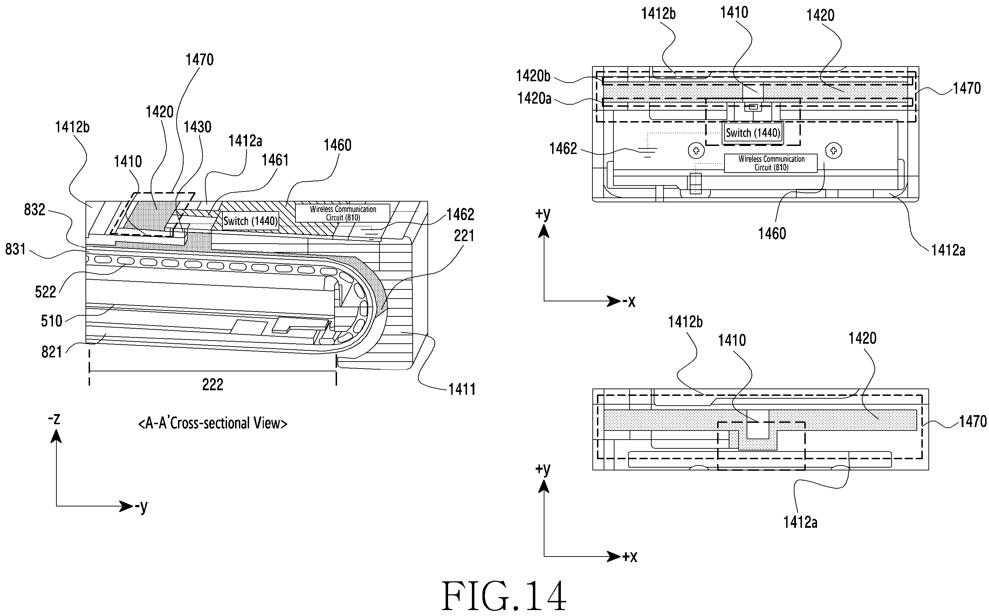

Accordingly, the slit 720 may be formed at the second position 1032 of the second portion 712. The second position 1032 may be a position adjacent to the first printed circuit board 760 disposed at the first position 1031. When the slit 720 is formed at the second position 1032, unlike cases in which the slit 720 is formed at the first position 1031 and the third position 1033, the slit 720 may affect radiation of RF signals in the second frequency band (e.g., about 900 to about 1100 MHz band); however, an influence thereof may be reduced or minimized through a switch circuit described below with reference to FIG. 14.

As a result, even when the slit 720 is formed at the second position 1032, the electronic device 101 may not only improve radiation performance in the first frequency band (e.g., about 600 to about 900 MHz band), but also maintain radiation performance equal to or greater than a predetermined value in the second frequency band (e.g., about 900 to about 1100 MHz band).

In FIG. 11 of the disclosure, the slit 720 has been described as being formed in the second portion 712; however, this is merely illustrative. The slit 720 formed in the second portion 712 may also be formed at the first position 1031. For example, the electronic device 101 may dispose the first printed circuit board 760 at a position other than the first position 1031, and the slit 720 may be formed at the first position 1031. In this case, radiation performance in the first frequency band (e.g., about 600 to about 900 MHz band) may be improved, and the slit 720 formed in the second portion 712 may substantially not affect radiation performance in the second frequency band (e.g., about 900 to about 1100 MHz band).

FIG. 12 illustrates radiation efficiency graphs in a case where a slit is not formed and in cases where the slit is formed at the first position to the third position according to an embodiment.

Referring to FIG. 12, a first graph 1200 according to an embodiment is a radiation efficiency graph in the case where the slit 720 is not formed. A second graph 1201 is a radiation efficiency graph in the case where the slit is formed at the first position 1031. A third graph 1202 is a radiation efficiency graph in the case where the slit 720 is formed at the second position 1032. A fourth graph 1203 is a radiation efficiency graph in the case where the slit is formed at the third position 1033.

When the third graph 1202 is compared with the first graph 1200, the second graph 1201, and the fourth graph 1203, it is identified that, in the case where the slit 720 is formed at the second position 1032, a parasitic resonance is formed in the second frequency band (e.g., about 900 to 1100 MHz band), as compared to the other cases. For example, the parasitic resonance in the second frequency band may reduce a radiation efficiency of an antenna that uses the second frequency band.

According to an embodiment, in order to minimize or reduce formation of a parasitic resonance in the second frequency band (e.g., about 900 to 1100 MHz band), the electronic device 101 may use a switch circuit (e.g., the switch circuit 1440 of FIG. 14) described below with reference to FIG. 14.

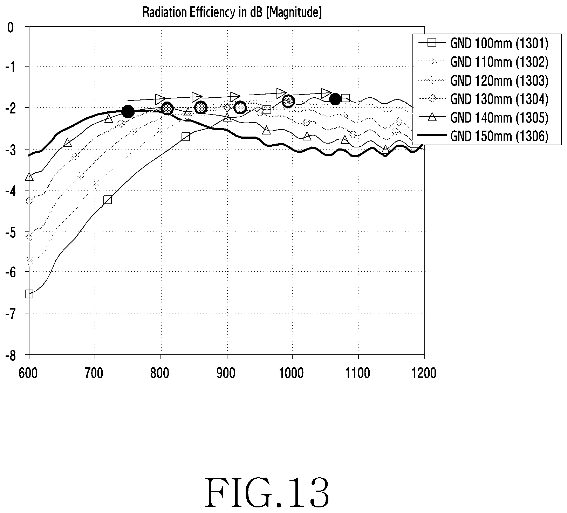

FIG. 13 illustrates radiation efficiency graphs of RF signals radiated by a first portion depending on respective lengths of an electronic device according to an embodiment.

Referring to FIG. 13, a first portion 711 according to an embodiment may operate as an antenna radiator, and the size (or the length in the vertical direction) of a ground of the electronic device 101 for the antenna radiator may vary depending on the length of the electronic device 101 (e.g., the length in the y-axis direction of FIG. 1). For example, when the electronic device 101 is in a first state, the electronic device 101 may have a second length L2 in the vertical direction (e.g., the y-axis direction of FIG. 1) (e.g., the second length L2 of FIG. 2), and the ground may also have a length or size corresponding to the second length L2. For example, when the electronic device 101 is in the second state, the electronic device 101 may have a third length L3 in the vertical direction (e.g., the y-axis direction of FIG. 1) (e.g., the third length L3 of FIG. 3), and the ground may also have a length or size corresponding to the third length L3.

For example, as the length of the electronic device 101 in the vertical direction (e.g., the y-axis direction of FIG. 1) increases, a ground in the electronic device 101 may also have a relatively large length or size.

According to an embodiment, as a size (or a length in the vertical direction) of the ground in the electronic device 101 becomes smaller, an antenna radiation efficiency value in a relatively low-frequency band may decrease. For example, when the length of the electronic device 101 in the vertical direction is the second length L2, the length of the ground may be smaller than in the case of the third length L3. In this case, an antenna radiation efficiency in a relatively low-frequency band may deteriorate, and an antenna radiation efficiency in a relatively high-frequency band may increase. In another example, when the length of the electronic device 101 in the vertical direction is the third length L3, the length of a ground may be greater than in the case of the second length L2. In this case, an antenna radiation efficiency in a relatively high-frequency band may deteriorate, and an antenna radiation efficiency in a relatively low-frequency band may increase.

Hereinafter, first to sixth graphs 1301 to 1306 illustrating radiation efficiency values in a frequency band (e.g., about 600 to about 1200 MHz) depending on a ground size (or a length in the vertical direction) will be described.

According to an embodiment, the first graph 1301 is a radiation efficiency graph of RF signals radiated by an antenna including the first portion 711 when the length of the electronic device 101 in the vertical direction is the second length L2 and the slit 720 is not formed. For example, the first graph 1301 may be referred to as an radiation efficiency of the antenna including the first portion 711 when the electronic device 101 is in the first state.

According to an embodiment, the second graph 1302 is a radiation efficiency graph of RF signals radiated by an antenna including the first portion 711 when the length of the electronic device 101 in the vertical direction is a fourth length and the slit 720 is not formed. The third graph 1303 is a radiation efficiency graph of RF signals radiated by an antenna including the first portion 711 when the length of the electronic device 101 in the vertical direction is a fifth length and the slit 720 is not formed. The fourth graph 1304 is a radiation efficiency graph of RF signals radiated by an antenna including the first portion 711 when the length of the electronic device 101 in the vertical direction is a sixth length and the slit 720 is not formed.

According to an embodiment, the fifth graph 1305 is a radiation efficiency graph of RF signals radiated by an antenna including the first portion 711 when the length of the electronic device 101 in the vertical direction is the third length L3 and the slit 720 is not formed. The sixth graph 1306 is a radiation efficiency graph of RF signals radiated by an antenna including the first portion 711 when the length of the electronic device 101 in the vertical direction is a seventh length and the slit 720 is not formed.

When the first graph 1301 and the second graph 1302 are compared, it is identified that the first graph 1301 shows a relatively low radiation efficiency value in the first frequency band (e.g., about 600 to about 900 MHz). Similarly, when the second graph 1302 and the third graph 1303 are compared, it is identified that the second graph 1302 shows a relatively low radiation efficiency value in the first frequency band (e.g., about 600 to about 900 MHz).

That is, when the first to sixth graphs 1301 to 1306 are considered, it is identified that, as the height of the electronic device 101 decreases, a radiation efficiency of RF signals radiated by the first portion 711 may deteriorate.

According to an embodiment, when the electronic device 101 is in the first state in which the height of the electronic device 101 is the smallest, the electronic device 101 may improve a radiation efficiency of RF signals radiated by the first portion 711 by using the slit 720 formed in the second portion 712. For example, as the slit 720 is formed in the second portion 712, an electrical path formed as the wireless communication circuit 810 feeds power to the first portion 711 may be formed not only in the first portion 711, but also in the conductive portion 730 corresponding to edges of the slit 720. As a result, by using the slit 720, the electronic device 101 may secure a relatively high radiation efficiency in the first frequency band corresponding to a relatively low-frequency band (e.g., about 600 to about 900 MHz), as compared to that shown in the first graph 1301.

FIG. 14 is a view illustrating a switch circuit connected to a ground according to an embodiment.

Referring to FIG. 14, an electronic device 101 according to an embodiment may include a first printed circuit board 1460, a switch circuit 1440 disposed on the first printed circuit board 1460, and/or a ground 1462. For example, the ground 1462 may be a conductive layer included in the first printed circuit board 1460. In another example, the ground 1462 may be a conductive material or a conductive substrate included in the electronic device 101.

The first printed circuit board 1460 of FIG. 14 of the disclosure may correspond to the first printed circuit board 760 of FIG. 7.

According to an embodiment, the electronic device 101 may include a frame 1410, and the frame 1410 may include a first portion 1411 and a second portion 1412 extending from the first portion 1411. The frame 1410 of FIG. 14 of the disclosure may correspond to the frame 710 of FIG. 7, the first portion 1411 may correspond to the first portion 711 of FIG. 7, and the second portion 1412 may correspond to the second portion 712 of FIG. 7.

According to an embodiment, the second portion 1412 may include a first part 1412a and a second part 1412b, and the first part 1412a and the second part 1412b may be distinguished from each other with reference to the slit 1420.

According to an embodiment, the second portion 1412 may include a conductive portion 1470 in which the slit 1420 is formed. For example, the conductive portion 1470 may be a portion surrounding edges of the slit 1420. For example, the conductive portion 1470 may be a portion in which the slit 1420 is formed. For example, the conductive portion 1470 may be a portion adjacent to the slit 1420. The slit 1420 of FIG. 14 of the disclosure may correspond to the slit 720 of FIG. 7, and the conductive portion 1470 may correspond to the conductive portion 730 of FIG. 7.

According to an embodiment, the second portion 1412 may include a protrusion 1410 extending from a first point of the conductive portion 1470 in which the slit 1420 is formed, in a direction toward the first printed circuit board 1460. For example, the second portion 1412 may include the protrusion 1410 extending from the first point of the conductive portion 1470 in which the slit 1420 is formed, in a second direction (e.g., the -y direction). In another example, the slit 1420 may include a first edge 1420a adjacent to the first printed circuit board 1460 and a second edge 1420b facing the first edge 1420a, and the protrusion 1410 may extend from the first point of the conductive portion 1470 forming the first edge 1420a toward the second edge 1420b.

According to an embodiment, the protrusion 1410 may include a conductive material, and the protrusion 1410 may be electrically connected to the first printed circuit board 1460 through a conductive connection member 1430. For example, the protrusion 1410 may extend from the first point of the slit 1420 and may be located in a front direction (e.g., the +z direction) with respect to the first printed circuit board 1460. The conductive connection member 1430 may be disposed between the protrusion 1410 and the first printed circuit board 1460, and the conductive connection member 1430 may electrically connect the protrusion 1410 and the first printed circuit board 1460.

Since the first printed circuit board 1460 may be connected to the protrusion 1410 through the conductive connection member 1430, and the protrusion 1410 extends from the conductive portion 1470 in which the slit 1420 is formed, the first printed circuit board 1460 may be electrically connected to the conductive portion 1470 in which the slit 1420 is formed, through the conductive connection member 1430 and the protrusion 1410.

In addition, since the switch circuit 1440 is disposed on or in the first printed circuit board 1460, the switch circuit 1440 may, as a result, be electrically connected to the conductive portion 1470 in which the slit 1420 is formed, through the conductive connection member 1430, the protrusion 1410, and the first printed circuit board 1460.

According to an embodiment, the switch circuit 1440 may control an electrical connection between the conductive portion 1470 in which the slit 1420 is formed and the ground 1462. For example, the switch circuit 1440 may electrically connect or electrically disconnect the conductive portion 1470 in which the slit 1420 is formed and the ground 1462. For example, when the switch circuit 1440 is opened, the conductive portion 1470 in which the slit 1420 is formed and the ground 1462 may be electrically disconnected. When the switch circuit 1440 is shorted, the conductive portion 1470 in which the slit 1420 is formed and the ground 1462 may be electrically connected.

According to an embodiment, the switch circuit 1440 may electrically connect the conductive portion 1470 in which the slit 1420 is formed and the ground 1462, or may electrically disconnect the conductive portion 1470 in which the slit 1420 is formed and the ground 1462, based on control of the wireless communication circuit 810 or the processor 120.

According to an embodiment, when the wireless communication circuit 810 transmits and/or receives RF signals in a second frequency band (e.g., about 900 to about 1100 MHz) higher than the first frequency band (e.g., about 600 to about 900 MHz), the wireless communication circuit 810 may control the switch circuit 1440 such that the conductive portion 1470 in which the slit 1420 is formed and the ground 1462 are electrically connected. When the wireless communication circuit 810 transmits and/or receives RF signals in the first frequency band (e.g., about 600 to about 900 MHz), the wireless communication circuit 810 may be configured to control the switch circuit 1440 such that the conductive portion 1470 in which the slit 1420 is formed and the ground 1462 are electrically disconnected.

According to an embodiment, when the wireless communication circuit 810 transmits RF signals in the first frequency band using the first portion 1411, the switch circuit 1440 may be opened, and when the wireless communication circuit 810 transmits RF signals in the second frequency band, the switch circuit 1440 may be shorted. Through this, the electronic device 101 may secure radiation performance equal to or greater than a predetermined value in the first frequency band and the second frequency band. For example, when the wireless communication circuit 810 transmits RF signals in the first frequency band using the first portion 1411, the switch circuit 1440 may electrically disconnect the conductive portion 1470 in which the slit 1420 is formed and the ground 1462. In this case, as an electrical path including the first portion 1411 and the conductive portion 1470 in which the slit 1420 is formed is formed, the electronic device 101 may secure radiation performance equal to or greater than a predetermined value in the first frequency band.

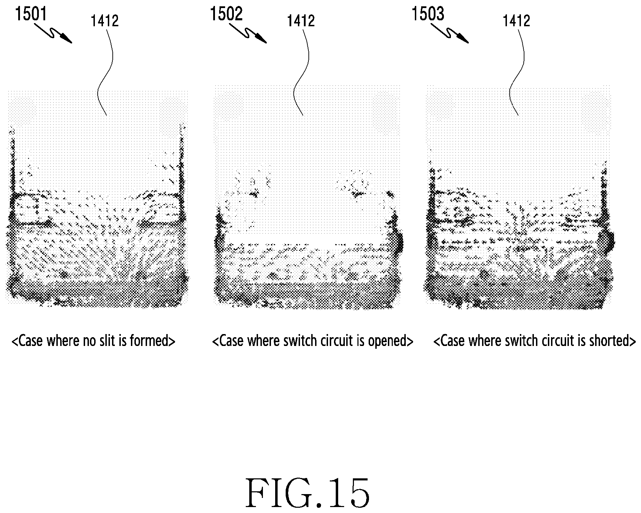

Meanwhile, when the wireless communication circuit 810 transmits RF signals in the second frequency band using another antenna, the switch circuit 1440 may electrically connect the conductive portion 1470 in which the slit 1420 is formed and the ground 1462. In this case, a current formed as power is fed to the first portion 1411 may be transmitted to the ground 1462 through the protrusion 1410, the conductive connection member 1430, and the switch circuit 1440. As the conductive portion 1470 in which the slit 1420 is formed is connected to the ground 1462, a current distribution similar to that in the case where the slit 720 is not formed may be formed, as will be described in FIG. 15 below.

For example, when the wireless communication circuit 810 transmits RF signals in the second frequency band, the slit 1420 may generate a parasitic resonance in the second frequency band (e.g., about 900 to about 1100 MHz), but by the switch circuit 1440 connecting the conductive portion 1470 in which the slit 1420 is formed to the ground 1462, the parasitic resonance generated in the second frequency band due to the slit 1420 may be reduced or minimized. Through this, the electronic device 101 may secure radiation performance equal to or greater than a predetermined value in the second frequency band.

As a result, when the electronic device 101 transmits RF signals in the first frequency band, the electronic device 101 may secure radiation performance in the first frequency band by using the slit 1420, and when the electronic device 101 transmits RF signals in the second frequency band, the electronic device 101 may secure radiation performance in the second frequency band by reducing or minimizing an influence of the slit 1420 by connecting the conductive portion 1470 in which the slit 1420 is formed and the ground 1462.

According to an embodiment, when the electronic device 101 is in the second state in which the first housing 111 is slid out from the second housing 112, the wireless communication circuit 810 may control the switch circuit 1440 such that the conductive portion 1470 in which the slit 1420 is formed and the ground 1462 are electrically connected. For example, when the electronic device 101 is in the first state in which the first housing 111 is slid into the second housing 112, the wireless communication circuit 810 may be configured to control the switch circuit 1440 such that the conductive portion 1470 in which the slit 1420 is formed and the ground 1462 are electrically disconnected.

According to an embodiment, the switch circuit 1440 may be opened or short-circuited based on a frequency band of RF signals transmitted and/or received by the wireless communication circuit 810 when the electronic device 101 is in the first state, and may be opened when the electronic device 101 is in the second state. For example, the wireless communication circuit 810 may identify that the electronic device 101 is in the first state, and when the wireless communication circuit 810 is transmitting and/or receiving, or is to transmit and/or receive, RF signals in the first frequency band, the wireless communication circuit 810 may control the switch circuit 1440 to cut off an electrical connection between the conductive portion 1470 in which the slit 1420 is formed and the ground 1462. In this case, as an electrical path including the first portion 1411 and the conductive portion 1470 in which the slit 1420 is formed is formed, the electronic device 101 may secure radiation performance equal to or greater than a predetermined value in the first frequency band even when the electronic device 101 is in the first state.

In another example, the wireless communication circuit 810 may identify that the electronic device 101 is in the first state, and when the wireless communication circuit 810 is transmitting and/or receiving, or is to transmit and/or receive, RF signals in the second frequency band, the wireless communication circuit 810 may control the switch circuit 1440 to electrically connect the conductive portion 1470 in which the slit 1420 is formed and the ground 1462. In this case, by electrically connecting the conductive portion 1470 in which the slit 1420 is formed and the ground 1462, the electronic device 101 may distribute a current in a manner similar to that in the case where the slit 1420 is not formed, as will be described in FIG. 15 below. Through this, the electronic device 101 may minimize or reduce parasitic resonance generated in the second frequency band (e.g., about 900 to about 1100 MHz band) due to the slit 1420 when the electronic device 101 is in the first state.

In another example, the wireless communication circuit 810 may identify that the electronic device 101 is in the second state, and may control the switch circuit 1440 to cut off an electrical connection between the conductive portion 1470 in which the slit 1420 is formed and the ground 1462.

When the electronic device 101 is in the second state, since the size of the ground of the electronic device 101 is relatively larger than in the first state, an antenna radiation efficiency in a relatively high-frequency band (e.g., the second frequency band) may be relatively deteriorated, and parasitic resonance may be generated due to the slit 1420. However, even when deterioration of radiation efficiency due to a ground size and parasitic resonance is taken into account, the antenna radiation efficiency of the electronic device 101 may be equal to or greater than a predetermined value (e.g., about 10 dB) when the electronic device 101 is in the second state, and accordingly, in the second state, the electronic device 101 may turn off the switch circuit 1440 regardless of an operating frequency of RF signals transmitted and/or received by the wireless communication circuit 810.

However, although it has been described that, in the second state, the wireless communication circuit 810 opens the switch circuit 1440, this is merely an example. For example, even in the second state, the wireless communication circuit 810 may control the switch circuit 1440 based on a frequency band transmitted and/or received by the wireless communication circuit 810. For example, when the electronic device 101 is in the second state and the wireless communication circuit 810 is to transmit and/or receive RF signals in the first frequency band, the wireless communication circuit 810 may open the switch circuit 1440. For example, when the electronic device 101 is in the second state and the wireless communication circuit 810 is to transmit and/or receive RF signals in the second frequency band, the wireless communication circuit 810 may short-circuit the switch circuit 1440.

According to an embodiment, when the wireless communication circuit 810 transmits and/or receives RF signals in a frequency band lower than the first frequency band (e.g., about 600 to about 900 MHz) in the second state, additional radiation performance may be secured by relatively increasing the length of an electrical path based on the slit 1420.

According to an embodiment, as the protrusion 1410 is electrically connected to the first printed circuit board 1460, the slit 1420 may be divided into a plurality of sub-slits.

According to an embodiment, the conductive connection member 1430 may include at least one of a C-clip, a pogo pin, an flexible printed circuit board (FPCB), an flexible RF cable (FRC), or a conductive adhesive tape.

The frame 1410, the first portion 1411, and the second portion 1412 of FIG. 14 may correspond, in order, to the frame 710, the first portion 711, and the second portion 712 of FIG. 7. Accordingly, the description of the frame 710, the first portion 711, and the second portion 712 may be applied to the frame 1410, the first portion 1411, and the second portion 1412, as long as there is no inconsistency.

FIG. 15 is a view illustrating, in comparison, current distributions in a case where a switch circuit is opened and in a case where the switch circuit is shorted, according to an embodiment.

Referring to FIG. 15, the case where the slit 1420 according to an embodiment is not formed in the second portion 1412 (1501) is illustrated.

According to an embodiment, the case where the slit 1420 is formed in the second portion 1412 and, as the switch circuit 1440 is opened, the conductive portion 1470 in which the slit 1420 is formed and the ground 1462 are electrically disconnected (1502) is illustrated. In addition, the case where the slit 1420 is formed in the second portion 1412 and, as the switch circuit 1440 is shorted, the conductive portion 1470 in which the slit 1420 is formed and the ground 1462 are electrically connected (1503) is illustrated.

According to an embodiment, in the case where the switch circuit 1440 is opened (1502), it is identified that a current is formed along an edge of the slit 1420. For example, when the wireless communication circuit 810 transmits RF signals in the first frequency band, or when the electronic device 101 is in the first state, the switch circuit 1440 may be opened, and as an electrical path is formed not only in the first portion 1411 but also in the conductive portion 1470 in which the slit 1420 is formed, radiation performance in the first frequency band (e.g., about 600 to about 900 MHz band) may be secured to be equal to or greater than a predetermined value.

According to an embodiment, in the case where the switch circuit 1440 is shorted (1503), it is identified that a current distribution substantially identical to that in the case where the slit 1420 is not formed is formed (1501). For example, when the wireless communication circuit 810 transmits RF signals in the second frequency band, or when the electronic device 101 is in the first state, the switch circuit 1440 may be shorted. In this case, as the conductive portion 1470 in which the slit 1420 is formed and the ground 1462 are electrically connected, a current distribution may be formed to be substantially identical or similar to that in the case where the slit 1420 is not formed. As a result, by shorting the switch circuit 1440, the electronic device 101 may secure an effect substantially identical to that in the case where the slit 1420 is not formed, and may minimize or reduce parasitic resonance formed in the second frequency band (e.g., about 900 to about 1100 MHz).

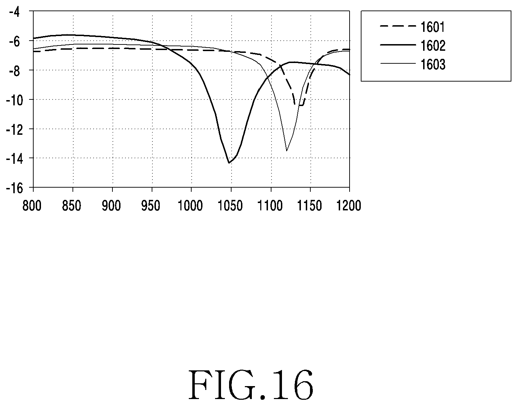

FIG. 16 is a view illustrating, in comparison, radiation-efficiency graphs in a case where a switch circuit is opened and in a case where the switch circuit is shorted, according to an embodiment.

Referring to FIG. 16, a first graph 1601 according to an embodiment is a radiation-efficiency graph of RF signals radiated from the first portion 1411 in the case where the slit 1420 is not formed in the second portion 1412 (1501). A second graph 1602 is a radiation-efficiency graph of RF signals radiated from the first portion 1411 in the case where the slit 1420 is formed in the second portion 1412 and the switch circuit 1440 is opened (1502). A third graph 1603 is a radiation-efficiency graph of RF signals radiated from the first portion 1411 in the case where the slit 1420 is formed in the second portion 1412 and the switch circuit 1440 is shorted (1503).

When the third graph 1603 is compared with the first graph 1601, it is identified that a lower radiation-efficiency value in a frequency band of about 900 to about 1100 MHz is shown in the third graph 1603 than in the first graph 1601. Similarly, when the third graph 1603 is compared with the second graph 1602, it is identified that a lower radiation-efficiency value in a frequency band of about 900 to about 1100 MHz is shown in the third graph 1603 than in the second graph 1602.

When the electronic device 101 transmits RF signals in the second frequency band in the case where the slit 1420 is formed in the second portion 1412 and the switch circuit 1440 is opened, radiation efficiency of RF signals in the second frequency band may be deteriorated. Accordingly, in order to prevent or reduce deterioration of radiation efficiency of RF signals in the second frequency band, the switch circuit 1440 may be shorted when the electronic device 101 transmits RF signals in the second frequency band.

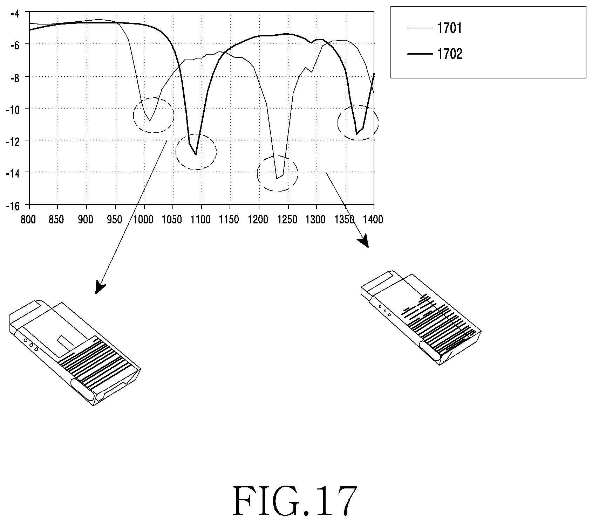

FIG. 17 illustrates radiation-efficiency graphs of antennas that radiate RF signals in the second frequency band depending on a size of a gap between a second portion 1412 and a flexible display according to an embodiment.

Referring to FIG. 17, a first graph 1701 according to an embodiment is a radiation-efficiency graph of an antenna that radiates RF signals in the second frequency band in a case where a gap between the second portion 1412 and the flexible display 220 is a first size (e.g., about 0.2 mm). A second graph 1702 is a radiation-efficiency graph of an antenna that radiates RF signals in the second frequency band in a case where a gap between the slit 1420 formed in the second portion 1412 and the flexible display 220 is a second size (e.g., about 0.6 mm).

When the first graph 1701 and the second graph 1702 are referred to, it is identified that parasitic resonance is generated in the second frequency band (e.g., about 900 to about 1100 MHz band) in both the case where the gap is the first size (e.g., about 0.2 mm) and the case where the gap is the second size (e.g., about 0.6 mm).

According to an embodiment, when the electronic device 101 is in the first state, the first display portion 221 of the flexible display 220 may be slid into the interior of the first frame 1410, and the gap between the first display portion 221 and the second portion 1412 of the first frame 1410 may correspond to the first size or the second size. In this case, radiation efficiency of an antenna that radiates RF signals in the second frequency band may be deteriorated.

Accordingly, in order to reduce or minimize parasitic resonance generated in the second frequency band (e.g., about 900 to about 1100 MHz) in the first state, the electronic device 101 may control the switch circuit 1440 to be shorted.

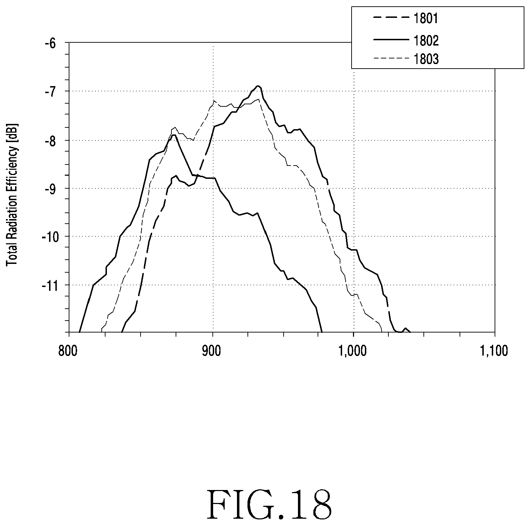

FIG. 18 is a view illustrating, in comparison, a case where a slit is not formed, a case where a slit and a ground are electrically disconnected, and a case where a slit and a ground are electrically connected, according to an embodiment.

Referring to FIG. 18, a first graph 1801 according to an embodiment is a radiation-efficiency graph of an antenna including the first portion 1411 in the case where the slit 1420 is not formed in the second portion 1412. A second graph 1802 is a radiation-efficiency graph of the antenna in the case where the slit 1420 is formed in the second portion 1412 and the slit 1420 and the ground 1462 are electrically disconnected. A third graph 1803 is a radiation-efficiency graph of the antenna in the case where the slit 1420 is formed in the second portion 1412 and the slit 1420 and the ground 1462 are electrically connected.

When the second graph 1802 is compared with the first graph 1801, the second graph 1802 shows a relatively higher antenna radiation-efficiency value in the first frequency band (e.g., about 600 to about 900 MHz band) than the first graph 1801. For example, when the slit 1420 is formed in the second portion 1412, the electronic device 101 may secure a relatively higher radiation efficiency in the first frequency band (e.g., about 600 to about 900 MHz band) than that in the case where the slit 1420 is not formed.

When the third graph 1803 is compared with the second graph 1802, the third graph 1803 shows a relatively higher radiation-efficiency value in the second frequency band (e.g., about 900 to about 1100 MHz band) than the second graph 1802. For example, the electronic device 101 may secure a relatively higher radiation efficiency in the second frequency band (e.g., about 900 to about 1100 MHz band) in the case where the slit 1420 is formed in the second portion 1412 and the slit 1420 and the ground 1462 are electrically connected, than in the case where the slit 1420 is formed in the second portion 1412 and the slit 1420 and the ground 1462 are electrically disconnected.

As a result, when the electronic device 101 transmits RF signals in the first frequency band, the electronic device 101 may secure antenna radiation performance in the first frequency band by electrically cutting off the slit 1420 and the ground 1462, and when the electronic device 101 transmits RF signals in the second frequency band, the electronic device 101 may secure antenna radiation performance in the second frequency band by electrically connecting the slit 1420 and the ground 1462.

FIG. 19 illustrates various widths of slits formed in the second portion according to an embodiment.

Referring to FIG. 19, a case in which a slit is not formed in the second portion 712 according to an embodiment (1901) is illustrated.

According to an embodiment, a case in which a slit 720 is formed in the second portion 712 (1902) is illustrated. The slit 720 may have a first width W1 (e.g., about 73 mm) and may have a first height H1.

According to an embodiment, a case in which a first slit 1921 is formed in the second portion 712 (1903) is illustrated. The first slit 1921 may have a second width W2 (e.g., about 53 mm) and may have the first height H1. The second width W2 may be smaller than the first width W1.

According to an embodiment, a case in which a second slit 1922 is formed in the second portion 712 (1904) is illustrated. The second slit 1922 may have a third width W3 (e.g., about 33 mm) and may have the first height H1. The third width W3 may be smaller than the first width W1 and may be smaller than the second width W2.

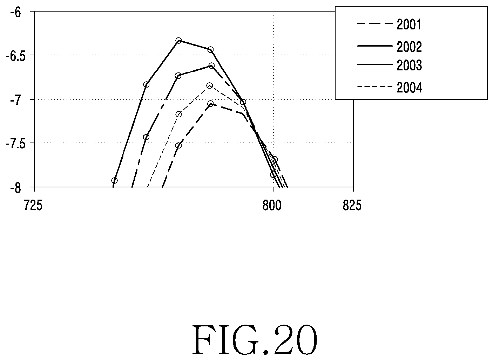

FIG. 20 illustrates radiation-efficiency graphs of antennas in cases where slits having various widths are formed according to an embodiment.

Referring to FIG. 20, a first graph 2001 according to an embodiment is a radiation-efficiency graph of an antenna including the first portion 711 in the case where a slit 720 is not formed in the second portion 712 (1901). A second graph 2002 is a radiation-efficiency graph of an antenna including the first portion 711 in the case where the slit 720 having the first width W1 is formed in the second portion 712 (1902). A third graph 2003 is a radiation-efficiency graph of an antenna including the first portion 711 in the case where the first slit 1921 having the second width W2 is formed in the second portion 712 (1903). A fourth graph 2004 is a radiation-efficiency graph of an antenna including the first portion 711 in the case where the second slit 1922 having the third width W3 is formed in the second portion 712 (1904).

When the first to fourth graphs 2001 to 2004 are compared, it is identified that, in a frequency band of about 750 to about 775 MHz, the second graph 2002, the third graph 2003, and the fourth graph 2004 show relatively higher radiation-efficiency values than the first graph 2001. For example, in the case where a slit (e.g., the slit 720) is formed in the second portion 712, the electronic device 101 may secure a relatively higher radiation-efficiency value in the frequency band of about 750 to about 770 MHz than in the case where a slit is not formed in the second portion 712.

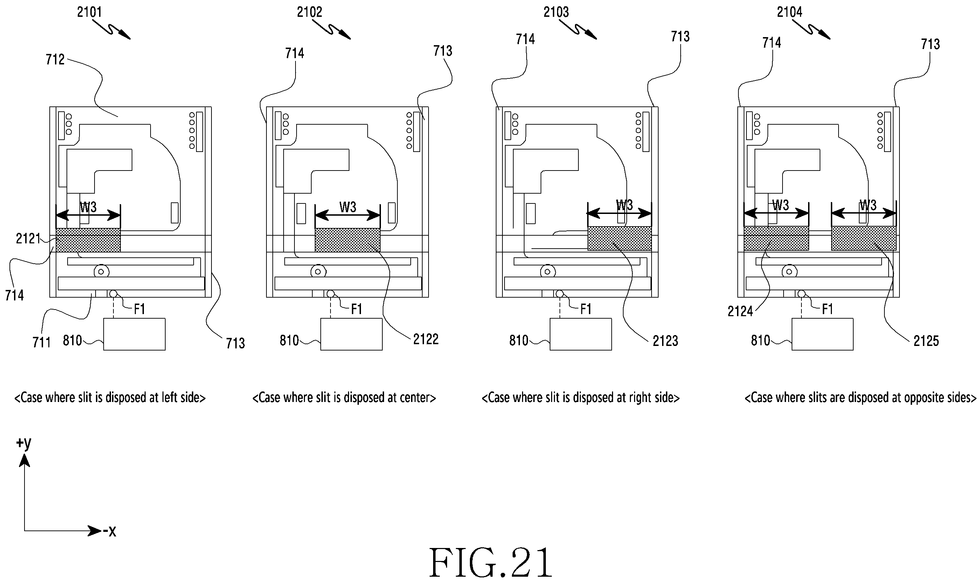

FIG. 21 illustrates various positions of slits formed in the second portion according to an embodiment.

Referring to FIG. 21, a case where a slit is formed on a left side of the second portion 712 according to an embodiment (2101) is illustrated. For example, a first slit 2121 may be formed in the second portion 712 so as to be adjacent to a fourth portion 714 of the frame 710. For example, the first slit 2121 may have a third width W3 (e.g., about 33 mm).

According to an embodiment, a case where a second slit 2122 is formed in the second portion 712 (2102) is illustrated. For example, the second slit 2122 may be formed to be located at a center of the second portion 712. The center of the second portion 712 may be referred to as a middle position between the third portion 713 and the fourth portion 714. For example, the second slit 2122 may have the third width W3 (e.g., about 33 mm).

According to an embodiment, a case where a third slit 2123 is formed in the second portion 712 (2103) is illustrated. For example, the third slit 2123 may be formed in the second portion 712 so as to be adjacent to the third portion 713 of the frame 710. For example, the third slit 2123 may have the third width W3 (e.g., about 33 mm).

According to an embodiment, a case where a fourth slit 2124 and a fifth slit 2125 are formed in the second portion 712 (2104) is illustrated. For example, the fourth slit 2124 may be formed in the second portion 712 so as to be adjacent to the fourth portion 714, and the fifth slit 2125 may be formed in the second portion 712 so as to be adjacent to the third portion 713. For example, the fourth slit 2124 may have the third width W3 (e.g., about 33 mm).

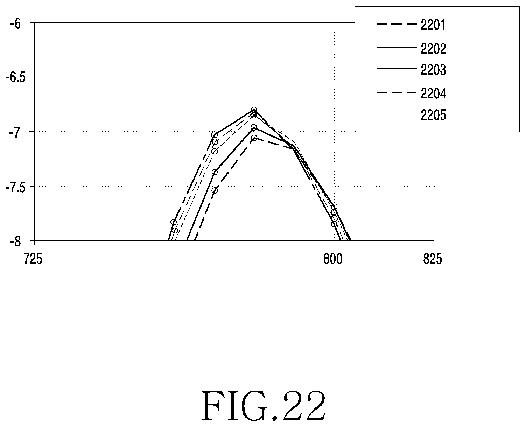

FIG. 22 illustrates radiation-efficiency graphs of antennas in cases where slits having various widths are formed according to an embodiment.

Referring to FIG. 22, a first graph 2201 according to an embodiment is a radiation-efficiency graph of an antenna including the first portion 711 in the case where a slit 720 is not formed in the second portion 712 (1901). A second graph 2202 is a radiation-efficiency graph of an antenna including the first portion 711 in the case where the first slit 2121 is formed in the second portion 712 (2101). A third graph 2203 is a radiation-efficiency graph of an antenna including the first portion 711 in the case where the second slit 2122 is formed in the second portion 712 (2102). A fourth graph 2204 is a radiation-efficiency graph of an antenna including the first portion 711 in the case where the third slit 2123 is formed in the second portion 712 (2103). A fifth graph 2205 is a radiation-efficiency graph of an antenna including the first portion 711 in the case where the fourth slit 2124 and the fifth slit 2125 are formed in the second portion 712 (2104).

When the first to fifth graphs 2201 to 2205 are compared, it is identified that, in a frequency band of about 750, the second graph 2202, the third graph 2203, the fourth graph 2204, and the fifth graph 2205 show relatively higher radiation-efficiency values than the first graph 2201. For example, in the case where a slit (e.g., the first slit 2121) is formed in the second portion 712, the electronic device 101 may secure a relatively higher radiation-efficiency value in the frequency band of about 750 MHz than in the case where a slit is not formed in the second portion 712.

According to an embodiment, as a distance between a slit and a feeding point decreases, a relatively higher radiation-efficiency value may be secured.

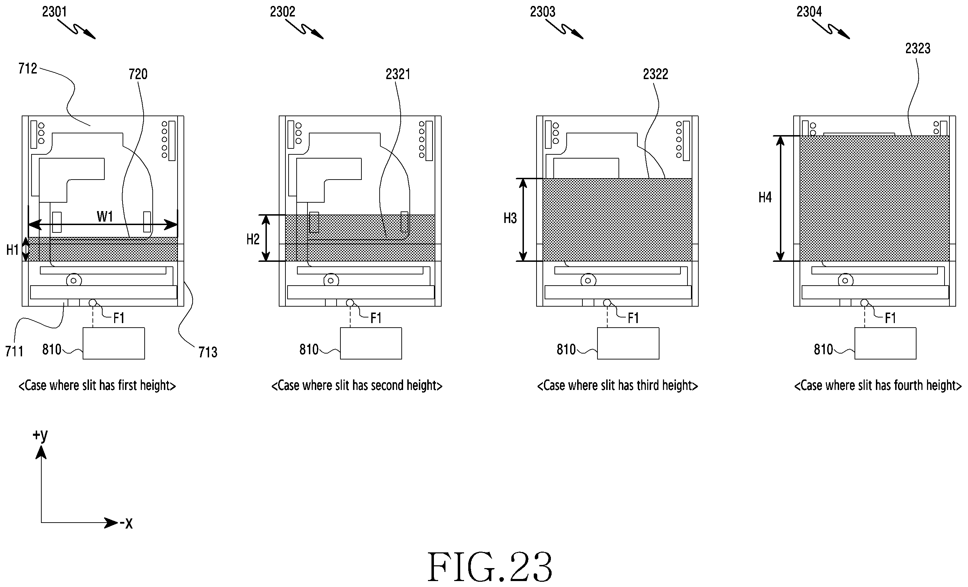

FIG. 23 illustrates various heights of slits formed in the second portion according to an embodiment.

Referring to FIG. 23, a case in which a slit 720 is formed in the second portion 712 according to an embodiment (2301) is illustrated. The slit 720 may have a first width W1 (e.g., about 73 mm) and may have a first height H1 (e.g., about 10 mm).

According to an embodiment, a case in which a first slit 2321 is formed in the second portion 712 (2302) is illustrated. The first slit 2321 may have the first width W1 (e.g., about 73 mm) and may have a second height H2 (e.g., about 20 mm). The second height H2 may be greater than the first height H1.

According to an embodiment, a case in which a second slit 2322 is formed in the second portion 712 (2303) is illustrated. The second slit 2322 may have the first width W1 (e.g., about 73 mm) and may have a third height H3 (e.g., about 40 mm). The third height H3 may be greater than the first height H1 and may be greater than the second height H2.

According to an embodiment, a case in which a third slit 2323 is formed in the second portion 712 (2304) is illustrated. The third slit 2323 may have the first width W1 (e.g., about 73 mm) and may have a fourth height H4 (e.g., about 60 mm). The fourth height H4 may be greater than the first height H1 and may be greater than the second height H2 and the third height H3.

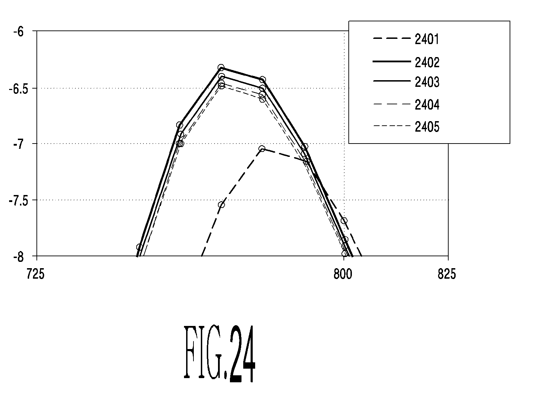

FIG. 24 illustrates radiation-efficiency graphs of antennas in cases where slits having various heights are formed according to an embodiment.

Referring to FIG. 24, a first graph 2401 according to an embodiment is a radiation-efficiency graph of an antenna including the first portion 711 in the case where a slit 720 is not formed in the second portion 712 (1901). A second graph 2402 is a radiation-efficiency graph of an antenna including the first portion 711 in the case where the slit 720 having the first height H1 is formed in the second portion 712 (2301). A third graph 2403 is a radiation-efficiency graph of an antenna including the first portion 711 in the case where the second slit 2321 having the second height H2 is formed in the second portion 712 (2302). A fourth graph 2404 is a radiation-efficiency graph of an antenna including the first portion 711 in the case where the second slit 2322 having the third height H3 is formed in the second portion 712 (2303). A fifth graph 2405 is a radiation-efficiency graph of an antenna including the first portion 711 in the case where the third slit 2323 having the fourth width H4 is formed in the second portion 712 (2304).

When the first to fifth graphs 2401 to 2405 are compared, it is identified that, in a frequency band of about 750 MHz to about 775 MHz, the second graph 2402, the third graph 2403, the fourth graph 2404, and the fifth graph 2405 show relatively higher radiation-efficiency values than the first graph 2401. For example, in the case where a slit (e.g., the slit 720) is formed in the second portion 712, the electronic device 101 may secure a relatively higher radiation-efficiency value in the frequency band of about 750 to about 770 MHz than in the case where a slit is not formed in the second portion 712. However, an influence of a height of a slit on antenna radiation efficiency may be substantially insignificant. For example, it may not always be the case that radiation efficiency increases as the height of the slit increases.

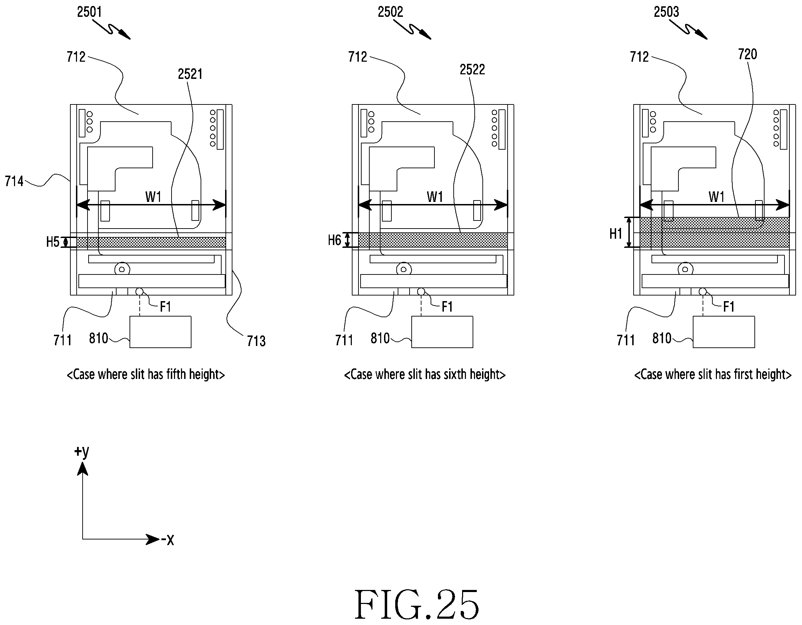

FIG. 25 illustrates various heights of slits formed in the second portion according to an embodiment.

Referring to FIG. 25, a case in which a first slit 2521 is formed in the second portion 712 according to an embodiment (2501) is illustrated. The first slit 2521 may have the first width W1 (e.g., about 73 mm) and may have a fifth height H5 (e.g., about 2 mm).

According to an embodiment, a case in which a second slit 2522 is formed in the second portion 712 (2502) is illustrated. The second slit 2522 may have the first width W1 (e.g., about 73 mm) and may have a sixth height H6 (e.g., about 5 mm). The sixth height H6 may be greater than the fifth height H5.

According to an embodiment, a case in which a slit 720 is formed in the second portion 712 (2503) is illustrated. The slit 720 may have a first width W1 (e.g., about 73 mm) and may have a first height H1 (e.g., about 10 mm). The first height H1 may be greater than the fifth height H5 and may be greater than the sixth height H6.

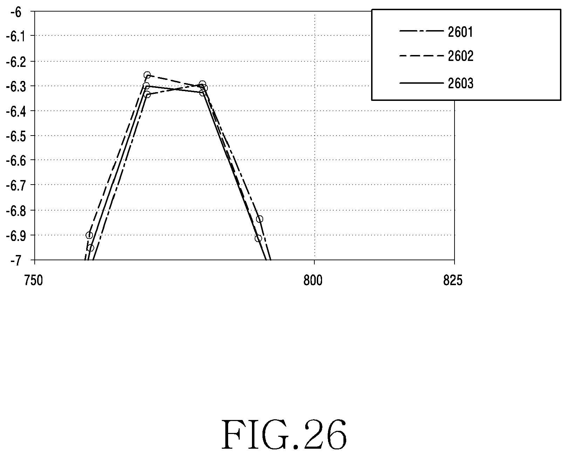

FIG. 26 illustrates radiation-efficiency graphs of antennas in cases where slits having various heights are formed according to an embodiment.

Referring to FIG. 26, a first graph 2601 according to an embodiment is a radiation-efficiency graph of an antenna including the first portion 711 in the case where the first slit 2521 having the fifth height H5 is formed in the second portion 712 (2501). A second graph 2602 is a radiation-efficiency graph of an antenna including the first portion 711 in the case where the second slit 2322 having the sixth height H6 is formed in the second portion 712 (2502). A third graph 2603 is a radiation-efficiency graph of an antenna including the first portion 711 in the case where the slit 720 having the first height H1 is formed in the second portion 712 (2503).

Referring to the first to third graphs 2601 to 2603, all of the first graph 2601, the second graph 2602, and the third graph 2603 show radiation-efficiency values equal to or greater than a predetermined value in a frequency band of about 750 to about 775 MHz. Even in the cases where the first slit 2521 having the fifth height H5 and the second slit 2522 having the sixth height H6 are formed, the electronic device 101 may secure high radiation-efficiency values in a frequency band of about 750 to about 770 MHz substantially in the same manner as in the case where the slit 720 is formed. However, a relatively higher radiation efficiency may be secured in the case where the second slit 2522 having the sixth height H6 is formed, as compared to the case where the first slit 2521 having the fifth height H5 is formed.

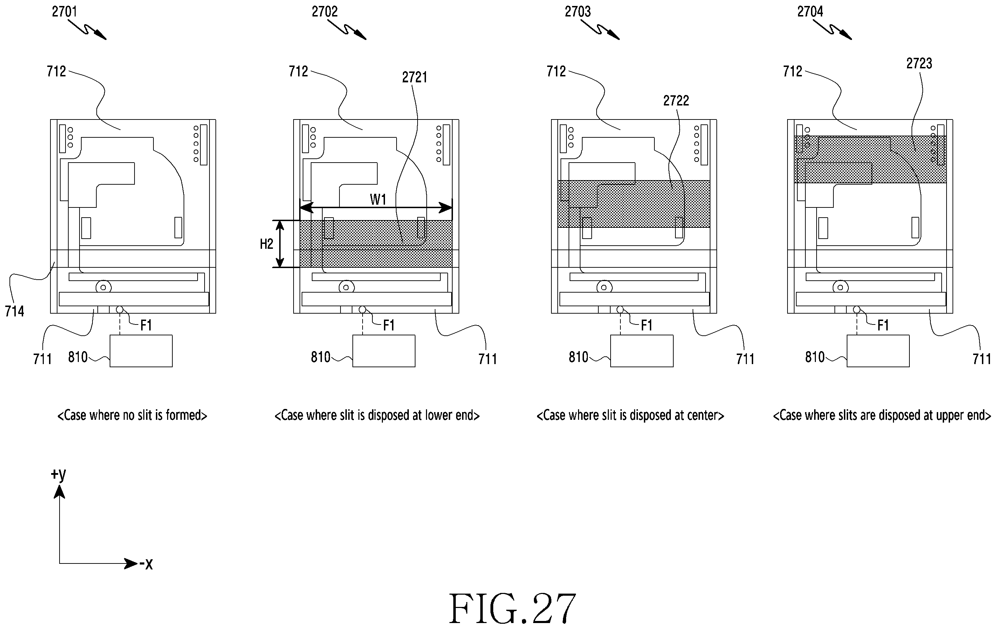

FIG. 27 illustrates various positions of slits formed in the second portion according to an embodiment.

Referring to FIG. 27, a case in which a slit is not formed in the second portion 712 according to an embodiment (2701) is illustrated.

According to an embodiment, a case in which a first slit 2721 is formed in at the lower end of the second portion 712 (2702) is illustrated. For example, the first slit 2721 may be formed in a portion of the second portion 712 that is adjacent to the first portion 711. For example, the first slit 2721 may have a first width W1 (e.g., about 73 mm) and may have a second height H2 (e.g., about 20 mm).

According to an embodiment, a case where a second slit 2722 is formed at a center of the second portion 712 (273) is illustrated. For example, the second slit 2722 may be formed in a central region between the upper and lower ends of the second portion 712. For example, the first slit 2721 may have the first width W1 (e.g., about 73 mm) and may have the second height H2 (e.g., about 20 mm).

According to an embodiment, a case in which a third slit 2723 is formed in at the upper end of the second portion 712 (2704) is illustrated. For example, the third slit 2723 may be formed in a portion of the second portion 712 that is spaced apart from the first portion 711 by at least a predetermined distance. The third slit 2723 may have the first width W1 (e.g., about 73 mm) and may have a second height H2 (e.g., about 20 mm).

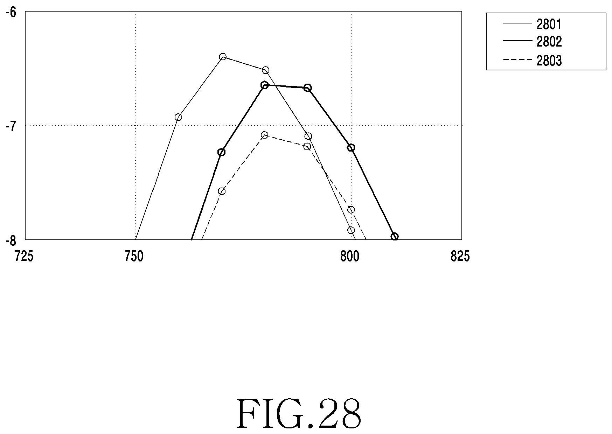

FIG. 28 illustrates radiation-efficiency graphs of antennas in cases where slits having various positions are formed according to an embodiment.

Referring to FIG. 28, a first graph 2801 according to an embodiment is a radiation-efficiency graph of an antenna including the first portion 711 in the case where the first slit 2721 is formed in at the lower end of the second portion 712 (2702). A second graph 2802 is a radiation-efficiency graph of an antenna including the first portion 711 in the case where the second slit 2722 is formed at the center of the second portion 712 (2703). A third graph 2803 is a radiation-efficiency graph of an antenna including the first portion 711 in the case where the third slit 2723 is formed at the upper end of the second portion 712 (2704).

Referring to the first to third graphs 2801 to 2803, in a frequency band of about 750 MHz to about 775 MHz, the first graph 2801 shows a relatively higher radiation-efficiency value than the second graph 2802 and the third graph 2803. For example, when a slit (e.g., the first slit 2721) is formed at the lower end of the second portion 712, the electronic device 101 may secure a relatively high radiation efficiency.

According to an embodiment, an electronic device 101 may include a first housing 111 including a rear surface cover 310, and including a frame 710 having a first portion 711 forming a portion of a side surface of the electronic device 101 and a second portion 712 extending from the first portion 711 to correspond to a rear surface cover 310, and a second housing 112 configured to be slid into an interior of the first housing 111 or to be slid out from the interior of the first housing 111. The electronic device may further include a slit 720 formed in the second portion 712 of the frame 710, a flexible display 220 including a metal layer 831, and a wireless communication circuit 810. The flexible display 220 may overlap, at least in part, the slit 720 in a first state in which the second housing 112 is slid into the first housing 111. The wireless communication circuit 810 may be configured to feed power to the first portion 711 of the frame 710 and to transmit and/or receive radio frequency (RF) signals in a first frequency band based on an electrical path formed in the first portion 711 of the frame 710 and in a conductive portion 730 in which the slit 720 is formed.

According to an embodiment, the flexible display 220 may include a first display portion 221 disposed inside the electronic device 101 in the first state, and a second display portion 222 exposed to an exterior of the electronic device through a front surface of the electronic device in a second state in which the second housing is slid out from the first housing.

According to an embodiment, the electronic device 101 may further include a roller unit 550 configured to slide out the flexible display 220 from the interior of the electronic device 101 or to slide the flexible display 220 into the interior of the electronic device 101, a plurality of bars disposed on a rear surface of the first display portion 221, and a plate disposed on a rear surface of the second display portion 222. As the plurality of bars move while the roller unit 550 rotates, the first display portion 221 may be exposed to the exterior of the electronic device 101 or may be slid into the interior of the electronic device 101 along the first portion and the second portion of the frame.

According to an embodiment, as the first display portion 221 overlaps the slit 720 in the first state, at least a portion of a first metal layer of the first display portion 221 may overlap the slit 720, and, in a second state in which the second housing is slid out from the first housing, the first display portion 221 may not overlap the slit 720.

According to an embodiment, the electronic device 101 may further include a first printed circuit board 760 disposed on the second portion of the frame to be disposed between the first portion of the frame and the slit and including a ground, and a switch circuit 1440 disposed on the first printed circuit board 760. The slit 720 includes a first edge adjacent to the first printed circuit board 760 and a second edge facing the first edge, and the switch circuit 1440 is electrically connected to a first point of the conductive portion 730 adjacent to the second edge.

According to an embodiment, the switch circuit 1440 may include at least one lumped element, and the switch circuit 1440 may electrically connect the conductive portion 730 in which the slit 720 is formed and the ground through the at least one lumped element.

According to an embodiment, the electronic device 101 may further include a protrusion extending from the conductive portion 730 and a conductive connection member connecting the protrusion and the switch circuit disposed on the first printed circuit board.

According to an embodiment, the protrusion may be formed to extend from a portion of the conductive portion 730 forming the first edge of the slit 720 toward the second edge of the slit 720.

According to an embodiment, a groove 850 in which an antenna for wireless charging and near-field communication (NFC) is disposed may be formed in the second portion of the frame, and the wireless communication circuit 810 disposed on the first printed circuit board may be configured to feed power to the antenna for the NFC and to transmit and/or receive RF signals in a predetermined frequency band.

According to an embodiment, when the wireless communication circuit 810 transmits and/or receives RF signals in a second frequency band higher than the first frequency band, the wireless communication circuit 810 may control the switch circuit such that the conductive portion 730 in which the slit 720 is formed and the ground are electrically connected, and when the wireless communication circuit 810 transmits and/or receives the RF signals in the first frequency band, the wireless communication circuit 810 may control the switch circuit 1440 such that the conductive portion 730 in which the slit 720 is formed and the ground are electrically disconnected.

According to an embodiment, the first frequency band may include 600 to 900 MHz, and the second frequency band may include 900 to 1100 MHz.

According to an embodiment, in a second state in which the second housing is slid out from the first housing, the wireless communication circuit 810 may control the switch circuit 1440 such that the conductive portion 730 in which the slit 720 is formed and the ground are electrically disconnected, and, in the first state, the wireless communication circuit 810 may control the switch circuit such that the conductive portion 730 and the ground are electrically connected or electrically disconnected based on the frequency band of the RF signals transmitted and/or received by the wireless communication circuit 810.

According to an embodiment, the first portion of the frame may include a conductive material, and the second portion of the frame may include a non-conductive region 751 including a non-conductive material and a conductive region 752 in which the slit is formed and which includes a conductive material, and the first printed circuit board 760 may be disposed on the non-conductive region 751.

According to an embodiment, the second portion 712 may correspond to the ground of the first portion 711 that is an antenna radiator, and, in the first state, the conductive portion 730 in which the slit 720 is formed may be disposed within a distance at which the conductive portion 730 may be electromagnetically coupled with the metal layer of the flexible display.

According to an embodiment, the metal layer 831 of the flexible display 220 may include a metal plate for supporting the flexible display 220.

According to an embodiment, an electronic device 101 may include a first housing 111 including a rear surface cover 310, and a frame including a first portion 711 forming a portion of a side surface of the electronic device 101 and a second portion 712 extending from the first portion 711 to correspond to the rear surface cover 310, and a second housing 112 configured to be slid into an interior of the first housing 111 or to be slid out from the interior of the first housing 111. The electronic device 101 may further include a slit 720 formed in a conductive portion 730 of the second portion 712 of the frame, a flexible display 220 including a metal layer, a first printed circuit board 760, and a switch circuit 1440 and a wireless communication circuit 810 disposed on the first printed circuit board 760. At leat a portion of the flexible display 220 may overlap the slit 720 in a first state in which the second housing 112 is slid into the first housing 111, the switch circuit 1440 may be electrically connected to the conductive portion 730, and the wireless communication circuit 810 may be configured to feed power to the first portion 711 of the frame and to transmit and/or receive radio frequency (RF) signals in a first frequency band based on an electrical path formed in the first portion 711 of the frame and in the conductive portion 730 in which the slit 720 is formed.

According to an embodiment, the first printed circuit board 760 may be disposed on the second portion 712 of the frame to be disposed between the first portion 711 of the frame and the slit 720, and the slit 720 may include a first edge adjacent to the first printed circuit board 760 and a second edge facing the first edge, and the switch circuit 1440 may be electrically connected to a first point of the conductive portion 730 adjacent to the second edge.

According to an embodiment, the switch circuit 1440 may include at least one lumped element, and the switch circuit 1440 may electrically connect the conductive portion 730 in which the slit 720 is formed and a ground through the at least one lumped element.

According to an embodiment, the electronic device 101 may further include a protrusion extending from the conductive portion and a conductive connection member connecting the protrusion and the switch circuit disposed on the first printed circuit board.

According to an embodiment, the protrusion may extend from a portion of the conductive portion 730 forming a first edge of the slit 720 toward the second edge facing the first edge.

## Claims

1. An electronic device comprising:
a first housing comprising a rear surface cover, and a frame including a first portion forming a portion of a side surface of the electronic device, and a second portion extending from the first portion to correspond to the rear surface cover;
a second housing formed to be slid into an interior of the first housing or to be slid out from the interior of the first housing;
a slit formed in a conductive portion of the second portion of the frame;
a flexible display comprising a metal layer, wherein at least a portion of the flexible display overlaps with the slit in a first state in which the second housing is slid into the first housing; and
a wireless communication circuit,
wherein the wireless communication circuit is configured to:
feed power to the first portion of the frame; and
transmit and/or receive radio frequency (RF) signals of a first frequency band based on an electrical path formed in the first portion of the frame and the conductive portion in which the slit is formed.

2. The electronic device of claim 1, wherein the flexible display comprises:
a first display portion disposed in an interior of the electronic device in the first state; and
a second display portion exposed to an exterior of the electronic device through a front surface of the electronic device in a second state in which the second housing is slid out from the first housing.

3. The electronic device of claim 2, further comprising:
a roller for withdrawing the flexible display from the interior of the electronic device or introducing the flexible display into the interior of the electronic device;
a plurality of bars disposed on a rear surface of the first display portion; and
a plate disposed on a rear surface of the second display portion,
wherein, as the plurality of bars move while the roller rotates, the first display portion is exposed to the exterior of the electronic device or is slid into the inside of the electronic device along the first portion and the second portion of the frame.

4. The electronic device of claim 2, wherein, in the first state, as the first display portion overlaps the slit, at least a portion of a first metal layer of the first display portion overlaps the slit, and
wherein. in a second state in which the second housing is slid out from the first housing, the first display portion does not overlap the slit.

5. The electronic device of claim 1, further comprising:
a first printed circuit board disposed on the second portion of the frame so as to be disposed between the first portion of the frame and the slit, the first printed circuit board comprising a ground; and
a switch circuit disposed on the first printed circuit board,
wherein the slit comprises a first edge adjacent to the first printed circuit board and a second edge facing the first edge, and
wherein the switch circuit is electrically connected to a first point of the conductive portion adjacent to the second edge.

6. The electronic device of claim 5, wherein the switch circuit comprises at least one lumped element, and
wherein the switch circuit electrically connects the conductive portion in which the slit is formed and the ground through the at least one lumped element.

7. The electronic device of claim 5, further comprising:
a protrusion extending from the conductive portion; and
a conductive connection member connecting the protrusion and the switch circuit disposed on the first printed circuit board.

8. The electronic device of claim 7, wherein the protrusion extends from a portion of the conductive portion forming the first edge of the slit toward the second edge of the slit.

9. The electronic device of claim 5, wherein a groove in which an antenna for wireless charging and near-field communication (NFC) is disposed is formed in the second portion of the frame, and
wherein the wireless communication circuit disposed on the first printed circuit board is configured to feed power to the antenna for the NFC and to transmit and/or receive RF signals in a designated frequency band.

10. The electronic device of claim 5, wherein the wireless communication circuit is configured to:
control the switch circuit such that the conductive portion in which the slit is formed and the ground are electrically connected in case that the wireless communication circuit transmits and/or receives radio frequency (RF) signals in a second frequency band higher than the first frequency band; and
control the switch circuit such that the conductive portion in which the slit is formed and the ground are electrically disconnected in case that the wireless communication circuit transmits and/or receives the RF signals in the first frequency band.

11. The electronic device of claim 10, wherein the first frequency band includes 600 to 900 MHz, and
wherein the second frequency band includes 900 to 1100 MHz.

12. The electronic device of claim 10, wherein the wireless communication circuit is configured to:
control the switch circuit such that the conductive portion in which the slit is formed and the ground are electrically disconnected in a second state in which the second housing is slid out from the first housing; and
control the switch circuit such that the conductive portion and the ground are electrically connected or electrically disconnected based on a frequency band of RF signals transmitted and/or received by the wireless communication circuit in the first state.

13. The electronic device of claim 1, wherein the first portion of the frame comprises a conductive material,
wherein the second portion of the frame comprises a non-conductive region including a non-conductive material and a conductive region in which the slit is formed and which comprises a conductive material; and
wherein a first printed circuit board is disposed on the non-conductive region.

14. The electronic device of claim 1, wherein the second portion corresponds to a ground of the first portion that is an antenna radiator, and
wherein, in the first state, the conductive portion in which the slit is formed is disposed within a distance at which the conductive portion is electromagnetically connectable to the metal layer of the flexible display.

15. The electronic device of claim 1, wherein the metal layer of the flexible display comprises a metal plate for supporting the flexible display.
